# EUROPEAN PATENT SPECIFICATION

(11) **EP 4 422 374 B1**
(45) Date of publication and mention of the grant of the patent: **24.12.2025**
(21) Application number: 24157475.5
(22) Date of filing: 13.02.2024
(51) Int. Cl.: H10K 50/844, H10K 59/122, H10K 59/88, H10K 71/20, H10K 102/00

(54) **DISPLAY PANEL AND MANUFACTURING METHOD FOR THE SAME**
ANZEIGETAFEL UND HERSTELLUNGSVERFAHREN DAFÜR
PANNEAU D'AFFICHAGE ET SON PROCÉDÉ DE FABRICATION

(30) Priority: 21.02.2023 KR 20230022682
(43) Date of publication of application: 28.08.2024
(73) Proprietor: Samsung Display Co., Ltd., Gyeonggi-Do (KR)
(72) Inventor: BAE, Subin, Yongin-si (KR); YANG, Hee Jun, Yongin-si (KR); KANG, Taewook, Yongin-si (KR); JUNG, Dawoon, Yongin-si (KR); JEONG, Yu-Gwang, Yongin-si (KR)
(74) Representative: Marks & Clerk LLP

(56) References cited:
- US-A1- 2023 013 772
- US-A1- 2023 041 252

## Description

### BACKGROUND

### 1. Field

The disclosure herein relates to a display panel and a method of manufacturing a display panel, and more particularly, to a display panel having improved durability and reliability.

### 2. Description of the Related Art

A display device, such as a television, a monitor, a smart phone, or a tablet, which provides an image to a user, includes a display panel for displaying an image. As such a display panel, various display panels such as a liquid crystal display panel, an organic light-emitting display panel, an electro-wetting display panel, and an electrophoretic display panel are being developed.

The organic light-emitting display panel may include an anode, a cathode, and a light-emitting pattern. The light-emitting pattern of a light-emitting region may be separated from another light-emitting pattern of another light-emitting region, and the cathode may provide a common voltage to each light-emitting region.

US2023013772A1 discloses a device comprises a substrate, pixel-defining layer structures arranged over the substrate, overhang structures arranged over an upper surface of the PDL structures, multiple sub-pixels, each sub-pixel is defined by a first overhang structure, and a second overhang structure adjacent to each other, the first overhang structure and the second overhang structure having a base portion arranged over the upper surface a PDL structure, a body portion arranged over the base portion, the body portion comprising a second metal of a second composition, and a top portion arranged over the body portion.

US2023041252A1 discloses a device comprising a substrate, a pixel-defining layer (PDL) structures disposed over the substrate and defining sub-pixels of the device, and a plurality overhang structures.

### SUMMARY

The disclosure provides a display panel which has a light-emitting element is formed without using a metal mask, the display panel having improved durability and capable of preventing the occurrence of a defect, and a method of manufacturing the display panel.

An embodiment of the inventive concept provides a display panel including a base layer, a pixel defining film disposed on the base layer and including an inorganic material, a bank layer which is disposed on the pixel defining film and in which a plurality of pixel openings is defined, a plurality of light-emitting elements disposed in each of the plurality of pixel openings and including an anode, a light-emitting pattern, and a cathode, where the cathode contacts the bank layer, a dummy pattern disposed on the bank layer, an inorganic encapsulation pattern disposed on the cathode and including a portion disposed on the dummy pattern, an organic pattern disposed on the inorganic encapsulation pattern, and an inorganic film disposed on the organic pattern, where a portion of the inorganic film is disposed between the dummy pattern and the bank layer.

In an embodiment, the plurality of pixel openings include a first pixel opening and a second pixel opening spaced apart from each other, and a light-emitting element of the plurality of light-emitting elements include a first light-emitting element disposed in the first pixel opening and including a first anode, a first light-emitting pattern, and a first cathode and a second light-emitting element disposed in the second pixel opening and including a second anode, a second light-emitting pattern, and a second cathode.

In an embodiment, the dummy pattern includes a first dummy pattern disposed adjacent to the first pixel opening and a second dummy pattern disposed adjacent to the second pixel opening, where the first dummy pattern is separated from the first light-emitting pattern and the first cathode and the second dummy pattern is separated from the second light-emitting pattern and the second cathode.

In an embodiment of the inventive concept, the display panel does further include an additional inorganic pattern disposed between the second dummy pattern and the bank layer.

In an embodiment, the inorganic encapsulation pattern does include a first inorganic encapsulation pattern disposed on the first light-emitting element and a second inorganic encapsulation pattern disposed on the second light-emitting element and spaced apart from the first inorganic encapsulation pattern, and the organic pattern does include a first organic pattern disposed on the first inorganic encapsulation pattern and a second organic pattern disposed on the second inorganic encapsulation pattern and spaced apart from the first organic pattern.

In an embodiment, the inorganic film does include a first inorganic portion disposed on the first organic pattern and a second inorganic portion disposed on the second organic pattern, where the first inorganic portion and the second inorganic portion may have different thicknesses from each other.

In an embodiment, the inorganic film does include a first inorganic portion disposed on the first organic pattern and a second inorganic portion disposed on the second organic pattern, where the first inorganic portion and the second inorganic portion do extend onto the bank layer so as to be connected to each other.

In an embodiment, the organic pattern does cover an entirety of the inorganic encapsulation pattern in a plan view.

In an embodiment, the inorganic film does include a spacer portion disposed between the dummy pattern and the bank layer and a layer portion having a shape separated from the spacer portion and covering the upper portions of the organic pattern and the bank layer.

In an embodiment of the inventive concept, the display panel may further include a capping pattern disposed on the cathode of the plurality of light-emitting elements.

In an embodiment, the dummy pattern may include a first layer dummy pattern including or consisting of a same material as that of the light-emitting pattern, a second layer dummy pattern including or consisting of a same material as that of the cathode, and a third layer dummy pattern including or consisting of a same material as that of the capping pattern.

In an embodiment, the dummy pattern may include a second layer dummy pattern including or consisting of a same material as that of the cathode and a third layer dummy pattern including or consisting of a same material as that of the capping pattern, and a predetermined separation portion may be defined between the second layer dummy pattern and the bank layer.

In an embodiment, the inorganic encapsulation pattern is disposed directly on the cathode and the dummy pattern, the organic pattern is disposed directly on the inorganic encapsulation pattern, and the inorganic film is disposed directly on the organic pattern.

In an embodiment of the inventive concept, the display panel may further include an encapsulation organic film which is disposed on the inorganic film and provides a flat upper surface and an upper encapsulation inorganic film disposed on the encapsulation organic film.

In an embodiment, the inorganic film may include a first inorganic film disposed directly on the organic pattern and a second inorganic film disposed on the first inorganic film.

In an embodiment, the bank layer may include a first conductive layer disposed on the pixel defining film and a second conductive layer disposed on the first conductive layer and having an undercut shape protruding from one side of the first conductive layer, and the dummy pattern may be disposed on the second conductive layer.

In an embodiment of the inventive concept, a display panel includes a base layer, a pixel defining film disposed on the base layer and including or consisting of an inorganic material, a bank layer disposed on the pixel defining film and having a plurality of pixel openings defined therein, a plurality of light-emitting elements disposed in each of the plurality of pixel openings and including an anode, a light-emitting pattern, and a cathode, where the cathode contacts the bank layer, a dummy pattern disposed on the bank layer, an inorganic encapsulation pattern disposed on the cathode and including a portion disposed on the dummy pattern, an organic pattern disposed on the inorganic encapsulation pattern, an inorganic film disposed on the organic pattern and the bank layer, an encapsulation organic film which is disposed on the inorganic film and provides a flat upper surface, and an upper encapsulation inorganic film disposed on the encapsulation organic film.

In an embodiment of the inventive concept, a method for manufacturing a display panel includes: providing a preliminary display panel including a base layer, a first anode disposed on the base layer, a preliminary pixel defining film disposed on the base layer and covering the first anode, and a preliminary bank layer disposed on the preliminary pixel defining film and including or consisting of a conductive material; defining a first pixel opening, which corresponds to the first anode and exposes an upper surface of the first anode, in the preliminary bank layer; forming a first light-emitting element in the first pixel opening by sequentially forming a first light-emitting pattern and a first cathode on the first anode; forming a first preliminary inorganic encapsulation layer covering the first light-emitting element and the preliminary bank layer: forming a first organic pattern which at least partially overlaps the first light-emitting element, on the first preliminary inorganic encapsulation layer; forming a first inorganic encapsulation pattern at least partially overlapping the first light-emitting element by etching the first preliminary inorganic encapsulation layer with the use of the first organic pattern as a mask, and forming a first preliminary inorganic film on the first organic pattern and the preliminary bank layer, where a portion of the first preliminary inorganic film is disposed between the first inorganic encapsulation pattern and the preliminary bank layer.

In an embodiment, the preliminary display panel does further include a second anode disposed on the base layer, the pixel defining film does cover the second anode, and after the forming of the first preliminary inorganic film, the method for manufacturing the display panel does further include: defining a second pixel opening, which corresponds to the second anode and exposes an upper surface of the second anode, in the preliminary bank layer; forming a second light-emitting element in the second pixel opening by sequentially forming a second light-emitting pattern and a second cathode on the second anode; forming a second preliminary inorganic encapsulation layer covering the second light-emitting element and the preliminary bank layer; forming a second organic pattern, which at least partially overlaps the second light-emitting element, on the second preliminary inorganic encapsulation layer; forming a second inorganic encapsulation pattern at least partially overlapping the second light-emitting element by etching the second preliminary inorganic encapsulation layer with the use of the second organic pattern as a mask; and forming a second preliminary inorganic film on the second organic pattern and the preliminary bank layer.

In an embodiment, in the forming of the second inorganic encapsulation pattern, a portion of the first preliminary inorganic film is etched, and a remaining portion of the first preliminary inorganic film does remain between the inorganic encapsulation pattern and the preliminary bank layer.

In an embodiment, in the forming of the first light-emitting element, a first preliminary dummy layer is formed on the preliminary bank layer, where the first preliminary dummy layer may include a (1-1)-th dummy layer including or consisting of a same material as that of the first light-emitting pattern and a (2-1)-th dummy layer including or consisting of a same material as that of the first cathode.

In an embodiment, in the forming of the first inorganic encapsulation pattern, a portion of the first preliminary dummy layer may be etched to form a first dummy pattern, and in the forming of the preliminary inorganic film, a portion of the first preliminary inorganic film may be formed to contact the first dummy pattern.

At least some of the above and other features of the invention are set out in the claims.

### BRIEF DESCRIPTION OF THE DRAWINGS

The accompanying drawings are included to provide a further understanding of the inventive concept, and are incorporated in and constitute a part of this specification. The drawings illustrate embodiments of the inventive concept and, together with the description, serve to explain principles of the inventive concept. In the drawings:
FIG. 1A is a combined perspective view of an embodiment of a display device according to the inventive concept;
FIG. 1B is an exploded perspective view of an embodiment of the display device according to the inventive concept;
FIG. 2 is a cross-sectional view of an embodiment of a display module according to the inventive concept;
FIG. 3 is a plan view of an embodiment of a display panel according to the inventive concept;
FIG. 4 is an equivalent circuit diagram of an embodiment of a pixel according to the inventive concept;
FIG. 5 is an enlarged plan view of an embodiment of a portion of a display region of the display panel according to the inventive concept;
FIG. 6A is a cross-sectional view of an embodiment of the display panel according to the inventive concept;
FIG. 6B is a cross-sectional view of an embodiment of the display panel according to the inventive concept;
FIGS. 7 and 8 are cross-sectional views of an embodiment of the display panel according to the inventive concept; and
FIGS. 9A to 9Q are cross-sectional views illustrating an embodiment of some operations of a method of manufacturing a display panel according to the inventive concept.

### DETAILED DESCRIPTION

Hereinafter, embodiments of the inventive concept will be described with reference to the drawings.

In this specification, it will be understood that when an element (or region, layer, portion, etc.) is referred to as being "on", "connected to" or "coupled to" another element, it can be directly on, connected or coupled to the other element, or intervening elements may be present.

Like reference numerals refer to like elements throughout. In addition, in the drawings, the thicknesses, ratios, and dimensions of elements are exaggerated for effective description of the technical contents. As used herein, the term "and/or" includes any and all combinations that the associated configurations can define.

It will be understood that, although the terms first, second, etc. may be used herein to describe various elements, these elements should not be limited by these terms. These terms are only used to distinguish one element from another element. For example, a first element could be termed a second element without departing from the scope of the present invention. Similarly, the second element may also be referred to as the first element. The terms of a singular form include plural forms unless otherwise specified.

In addition, terms, such as "below", "lower", "above", "upper" and the like, are used herein for ease of description to describe one element's relation to another element(s) as illustrated in the drawing figures. The above terms are relative concepts and are described based on the directions indicated in the drawings.

It will be understood that the terms "include" and/or "have", when used in this specification, specify the presence of stated features, integers, steps, operations, elements, components and/or groups thereof, but do not preclude the presence or addition of one or more other features, integers, steps, operations, elements, components, and/or groups thereof.

In the application, being "directly disposed" may mean that there is no layer, film, region, plate, or the like added between a part such as a layer, film, region, or plate and another part such as a layer, film, region, or plate. For example, being "directly disposed" may mean that no additional member such as an adhesive member is disposed between two layers or two members.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). The term "about" can mean within one or more standard deviations, or within ± 30%, 20%, 10%, 5% of the stated value, for example.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, a display device in an embodiment of the inventive concept will be described with reference to the drawings.

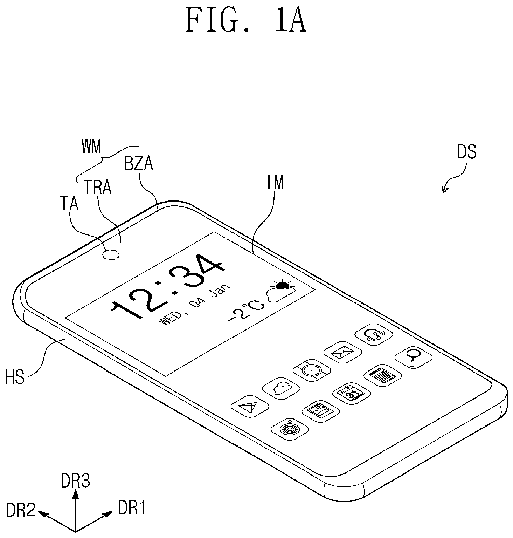

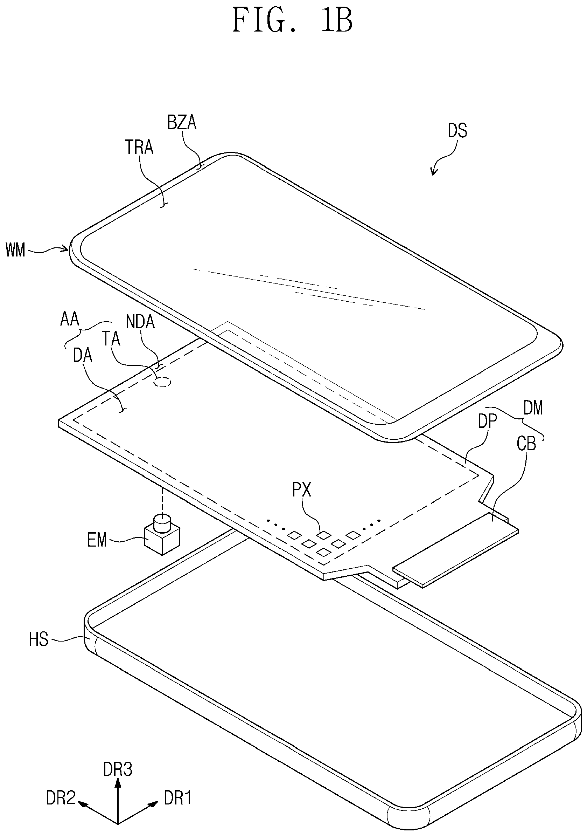

FIG. 1A is a combined perspective view of an embodiment of a display device according to the inventive concept. FIG. 1B is an exploded perspective view of an embodiment of the display device according to the inventive concept. Hereinafter, this inventive concept will be described with reference to FIGS. 1A and 1B.

The display device DS may display an image IM. In an embodiment, the display device DS may include a tablet, a laptop computer, a computer, a smart phone, a television, or the like, for example. In this embodiment, the display device DS is illustrated as a smart phone.

A user receives information through an image IM displayed in an active region AA. The image IM may include at least any one of a static image or a dynamic image. FIG. 1A illustrates a clock and a plurality of icons in an embodiment of the image IM.

The display device DS may include a window WM, a display module DM, an electronic module EM, and a housing unit HS. The window WM is coupled to the housing unit HS to form the exterior of the display device DS.

The window WM may include or consist of an optically transparent insulating material. In an embodiment, the window WM may include or consist of glass or plastic. The window WM may have a multi-layered or single-layered structure. In an embodiment, the window WM may have a stacked structure of a plurality of plastic films bonded to each other by an adhesive, or a stacked structure of a glass substrate and a plastic film bonded to each other by an adhesive.

The window WM includes a transparent region TRA and a bezel region BZA. The transparent region TRA may be an optically transparent region. An image IM generated by the display module DM may be viewed from the outside of the display device DS through the transparent region TRA.

The transparent region TRA may have a shape corresponding to that of the active region AA, which will be described later. The transparent region TRA may have a tetragonal shape parallel to each of a first direction DR1 and a second direction DR2. However, this is illustrated as an illustrative embodiment, and the transparent region TRA may have various shapes and is not limited to any particular embodiment.

The bezel region BZA is adjacent to the transparent region TRA. The bezel region BZA may have a relatively low light transmittance compared to the transparent region TRA. When the window WM is provided as a glass or plastic substrate, the bezel region BZA may be a color layer printed or deposited on one surface of a glass or plastic substrate. In an alternative embodiment, the bezel region BZA may be formed by coloring a corresponding region of the glass or plastic substrate.

The bezel region BZA defines the shape of the transparent region TRA. The bezel region BZA may be adjacent to and surround the transparent region TRA. However, this is illustrated as an illustrative embodiment, and the bezel region BZA may be disposed adjacent to only one side of the transparent region TRA or may be omitted.

A direction DR3 (hereinafter referred to as a third direction) perpendicular to the transparent region TRA may correspond to the thickness direction of the display device DS. An image IM is displayed toward the third direction DR3. In this embodiment, the front surface (or upper surface) and the rear surface (or lower surface) of each member are defined based on a direction in which the image IM is displayed. The front surface and the rear surface are opposed to each other in the third direction DR3.

Directions indicated by the first to third directions DR1, DR2, and DR3 are relative concepts and may be converted into other directions. Hereinafter, the first to third directions refer to the same reference numerals as directions indicated by the first to third directions DR1, DR2, and DR3, respectively.

The display module DM is disposed between the window WM and the housing unit HS. The display module DM may be accommodated in a space provided by coupling the window WM to the housing unit HS. The display module DM may include a display panel DP and a circuit board CB.

The front surface of the display panel DP includes the active region AA and a non-display region NDA. The active region AA may be a region in which a plurality of pixels PX is disposed. The pixels PX generate an image IM.

The active region AA includes a display region DA and a transmission region TA. The display region DA may be a region in which a plurality of light-emitting pixels among the pixels PX is disposed, and an image IM is displayed by light generated by the light-emitting pixels. A detailed description of this will be provided later.

The transmission region TA may have a relatively high transmittance compared to the display region DA. The transmission region TA may be a region in which a transmission pixel among the pixels is disposed. In addition, a relatively small number of light-emitting pixels may be disposed in the transmission region TA compared to the display region DA. In an embodiment, the density of light-emitting pixels disposed in the transmission region TA may be lower than the density of light-emitting pixels disposed in the display region DA. In an alternative embodiment, the light-emitting pixels may not be disposed in the transmission region TA.

The transmission region TA is defined adjacent to the display region DA. In this embodiment, the transmission region TA is defined as being entirely surrounded by the display region DA. However, this is illustrated as an illustrative embodiment, and the transmission region TA may be defined at a position partially adjacent to the display region DA or may be provided in various shapes other than a circular shape, and the inventive concept is not limited to any particular embodiment.

The non-display region NDA is adjacent to the active region AA. The non-display region NDA may be a region in which the pixels PX are not disposed. Driving circuits for driving the pixels PX may be disposed in the non-display region NDA.

The circuit board CB is connected to the display panel DP. The circuit board CB is illustrated as being coupled to the display panel DP in the non-display region NDA. The circuit board CB is electrically connected to the display panel DP. Various electronic elements for driving the pixels PX may be disposed (e.g., mounted) on the circuit board CB. This is illustrated as an illustrative embodiment, and various electronic elements for driving the pixels PX may be disposed (e.g., mounted) on the display panel DP, and in this case, the circuit board CB may be omitted. The display device DS in an embodiment of the inventive concept may include various embodiments, and the inventive concept is not limited to any particular embodiment.

The electronic module EM is disposed between the window WM and the housing unit HS. The electronic module EM may be accommodated in a space provided by coupling the window WM to the housing unit HS. The electronic module EM is disposed to overlap the display panel DP in a plan view.

On a plane, the electronic module EM overlaps the active region AA of the display panel DP and the transparent region TRA of the window WM. The electronic module EM is disposed to overlap the transmission region TA of the active region AA.

The electronic module EM may include a photographing module such as a camera, a light-receiving module such as an infrared detector, a sound module such as a speaker, a module such as an ultrasonic sensor, or the like. In this embodiment, the electronic module EM may capture a subject existing outside the display device DS through the transmission region TA or receive an external input, such as a touch or light, which is provided to the transparent region TRA. As the electronic module EM is disposed to overlap the display panel DP, it is possible to prevent an increase in the bezel region BZA and provide a narrow bezel display device or a borderless display device. This is illustrated as an illustrative embodiment, and the electronic module EM may be disposed to overlap the non-display region NDA and not to overlap the display panel DP, and the inventive concept is not limited to any particular embodiment.

In addition, in this inventive concept, the display device DS is illustrated as a flat rigid device, but may be a foldable device. In this case, the display device DS may be folded or unfolded around a folding axis overlapping at least a portion of the active region AA, and the display panel DP may be provided to be flexible. The display device DS in an embodiment of the inventive concept may be provided in various embodiments as long as it may display an image, and the inventive concept is not limited to any particular embodiment.

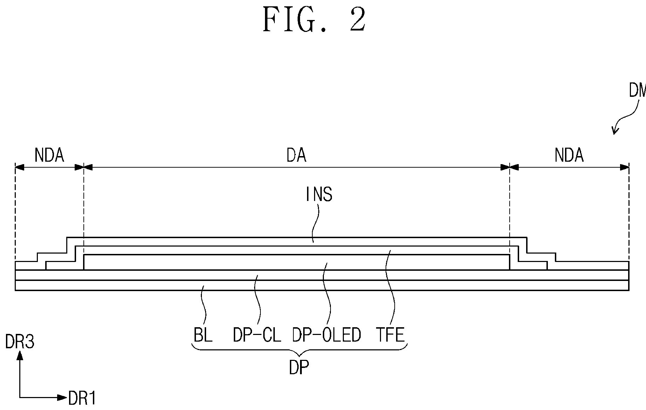

FIG. 2 is a cross-sectional view of an embodiment of a display module according to the inventive concept.

Referring to FIG. 2, the display module DM may include a display panel DP and an input sensor INS. Although not separately illustrated, the display device DS (refer to FIG. 1A) in an embodiment of the inventive concept may further include a protective member disposed on the lower surface of the display panel DP, or an anti-reflection member and/or a window member disposed on the upper surface of the input sensor INS.

The display panel DP may be a light-emitting display panel. However, This is an illustrative embodiment and the embodiment of the inventive concept is not particularly limited thereto. In an embodiment, the display panel DP may be an organic light-emitting display panel or an inorganic light-emitting display panel. A light-emitting layer in the organic light-emitting display panel may include or consist of an organic light-emitting material. A light-emitting layer in the inorganic light-emitting display panel may include or consist of quantum dots, quantum rods, or micro light-emitting diodes ("LEDs"). Hereinafter, the display panel DP will be described as an organic light-emitting display panel.

The display panel DP may include a base layer BL, a circuit element layer DP-CL disposed on the base layer BL, a display element layer DP-OLED, and a thin film encapsulation layer TFE. The input sensor INS may be disposed directly on the thin film encapsulation layer TFE. In this specification, "composition A is disposed directly on composition B" means that an adhesive layer is not disposed between composition A and composition B.

The base layer BL may include at least one plastic film. The base layer BL may be a flexible substrate and include a plastic substrate, a glass substrate, a metal substrate, an organic/inorganic composite material substrate, or the like. The display region DA and the non-display region NDA described with reference to FIG. 1B may be equally defined in the base layer BL.

The circuit element layer DP-CL may include at least one insulating layer and a circuit element. The insulating layer includes at least one inorganic layer and at least one organic layer. The circuit element includes signal lines, a pixel driving circuit, or the like.

The display element layer DP-OLED may include a barrier rib and a light-emitting element. The light-emitting element may include an anode, an intermediate layer, and a cathode.

The thin film encapsulation layer TFE may include a plurality of thin films. Some thin films may be disposed to improve optical efficiency, and some thin films may be disposed to protect organic light-emitting diodes.

The input sensor INS acquires the coordinate information of an external input. The input sensor INS may have a multi-layered structure. The input sensor INS may include a single conductive layer or a plurality of conductive layers. In addition, the input sensor INS may include a single insulating layer or a plurality of insulating layers. The input sensor INS may sense an external input in a capacitive manner. However, this is an illustrative embodiment, and the embodiment of the inventive concept is not limited thereto. In an embodiment of the inventive concept, the input sensor INS may sense an external input in an electromagnetic induction manner or a pressure-sensing manner, for example. In another embodiment of the inventive concept, the input sensor INS may be omitted.

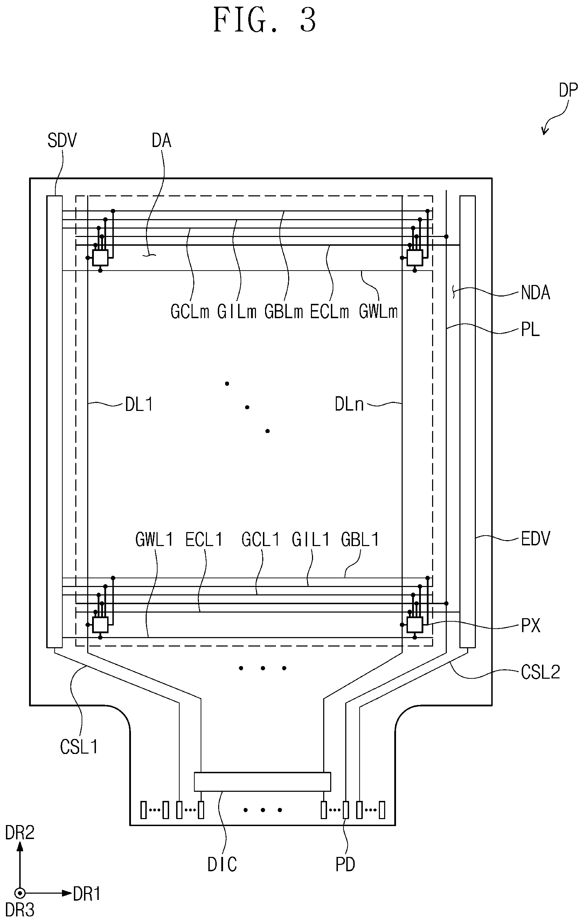

FIG. 3 is a plan view of an embodiment of a display panel according to the inventive concept.

Referring to FIG. 3, a display region DA and a non-display region NDA around the display region DA may be defined in the display panel DP. The display region DA and the non-display region NDA may be distinguished from each other according to whether or not pixels PX are disposed. The pixels PX may be disposed in the display region DA. A scan driver SDV, a data driver, and a light-emitting driver EDV may be disposed in the non-display region NDA. The data driver may be a portion of a circuit configured in a driving chip DIC.

The display panel DP may include pixels PX, initialization scan lines GIL1-GILm, compensation scan lines GCL1-GCLm, write scan lines GWL1-GWLm, black scan lines GBL1-GBLm, light-emitting control lines ECL1 to ECLm, data lines DL1 to DLn, first and second control lines CSL1 and CSL2, a driving voltage line PL, and a plurality of pads PD, where m and n are natural numbers greater than or equal to 2.

The pixels PX may be connected to the initialization scan lines GIL1-GILm, the compensation scan lines GCL1-GCLm, the write scan lines GWL1-GWLm, the black scan lines GBL1-GBLm, the light-emitting control lines ECL1-ECLm, and the data lines DL1-DLn.

The initialization scan lines GIL1-GILm, the compensation scan lines GCL1-GCLm, the write scan lines GWL1-GWLm, and the black scan lines GBL1-GBLm may extend in the first direction DR1 to be electrically connected to the scan driver SDV. The data lines DL1 to DLn may extend in the second direction DR2 to be electrically connected to the driving chip DIC. The light-emitting control lines ECL1-ECLm may extend in the first direction DR1 to be electrically connected to the light-emitting driver EDV.

The driving voltage line PL may include a portion extending in the first direction DR1 and a portion extending in the second direction DR2. The portion extending in the first direction DR1 and the portion extending in the second direction DR2 may be disposed in different layers. The driving voltage line PL may provide a driving voltage to pixels PX.

The first control line CSL1 may be connected to the scan driver SDV. The second control line CSL2 may be connected to the light-emitting driver EDV.

The driving chip DIC, the driving voltage line PL, the first control line CSL1 and the second control line CSL2 may be electrically connected to the pads PD. The circuit board CB (refer to FIG. 1B) may be electrically connected to the pads PD through an anisotropic conductive adhesive layer. The pads PD may connect the circuit board CB (refer to FIG. 1B) to the display panel DP. The pads PD may be connected to corresponding pixels PX through the driving voltage line PL, the first control line CSL1, and the second control line CSL2.

In addition, the pads PD may further include input pads. The input pads may connect the circuit board CB (refer to FIG. 1B) to the input sensor INS (refer to FIG. 2). Without being limited thereto, however, the input pads may be disposed on the input sensor INS and connected to the pads PD and a separate circuit board. In an alternative embodiment, the input sensor INS may be omitted and may not further include the input pads.

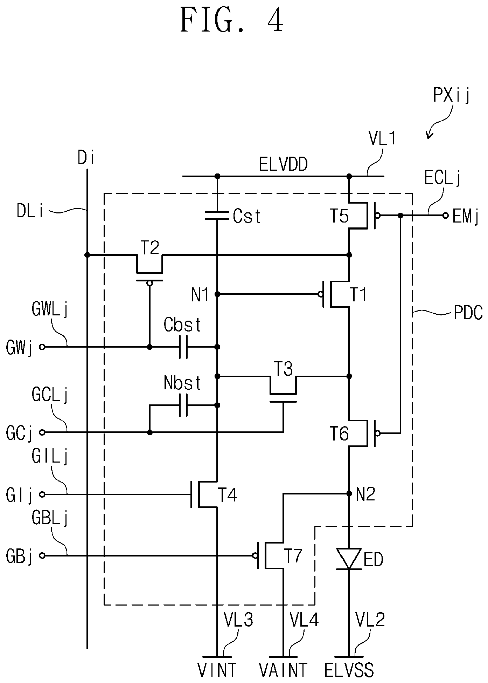

FIG. 4 is an equivalent circuit diagram of an embodiment of a pixel according to the inventive concept.

FIG. 4 illustrates an equivalent circuit diagram of one pixel PXij among a plurality of pixels PX (refer to FIG. 3). Since each of the plurality of pixels PX has a same circuit structure, the description of the circuit structure of the pixel PXij will be applied to the other pixels PX, and a detailed description of the other pixels PX will be omitted.

Referring to FIGS. 3 and 4, the pixel PXij is connected to an i-th data line DLi among the data lines DL1-DLn, a j-th initialization scan line GILj among the initialization scan lines GIL1-GILm, a j-th compensation scan line GCLj among the compensation scan lines GCL1-GCLm, a j-th write scan line GWLj among the write scan lines GWL1-GWLm, a j-th black scan line GBLj among the black scan lines GBL1-GBLm, a j-th light-emitting control line ECLj among the light-emitting control lines ECL1-ECLm, first and second driving voltage lines VL1 and VL2, and first and second initialization voltage lines VL3 and VL4, where i is an integer of 1 to n, and j is an integer of 1 to m.

The pixel PXij includes a light-emitting element ED and a pixel circuit PDC. The light-emitting element ED may be a light-emitting diode. In an embodiment of the inventive concept, the light-emitting element ED may be an organic light-emitting diode including an organic light-emitting layer, but is not particularly limited thereto. The pixel circuit PDC may control the amount of current flowing through the light-emitting element ED in response to a data signal Di. The light-emitting element ED may emit light having a predetermined luminance in response to the amount of current provided from the pixel circuit PDC.

The pixel circuit PDC may include first to seventh transistors T1, T2, T3, T4, T5, T6, and T7, and first to third capacitors Cst, Cbst, and Nbst. The configuration of the pixel circuit PDC according to this inventive concept is not limited to the embodiment illustrated in FIG. 4. The pixel circuit PDC illustrated in FIG. 4 is only an example, and the configuration of the pixel circuit PDC may be modified.

At least one of the first to seventh transistors T1, T2, T3, T4, T5, T6, and T7 may have a low-temperature polycrystalline silicon ("LTPS") semiconductor layer. At least one of the first to seventh transistors T1, T2, T3, T4, T5, T6, and T7 may have an oxide semiconductor layer. In an embodiment, the third and fourth transistors T3 and T4 may be oxide semiconductor transistors, and the first, second, fifth, sixth, and seventh transistors T1, T2, T5, T6, and T7 may be LTPS transistors, for example.

Specifically, the first transistor T1, which directly affects the brightness of the light-emitting element ED, may include a semiconductor layer composed of highly reliable polycrystalline silicon, and through this, it is possible to implement a high-resolution display device. Since an oxide semiconductor has a relatively high carrier mobility and a relatively low leakage current, a voltage drop is not substantially great even when a driving time is long. That is, since a color change of an image due to the voltage drop is not substantially great even during low-frequency driving, the low-frequency driving is possible. As described above, since the oxide semiconductor has an advantage that leakage current is small, it is possible not only to prevent leakage current, which may flow to a gate electrode, but also to reduce power consumption by adopting, as an oxide semiconductor, at least one of the third transistor T3 or the fourth transistor T4 connected to the driving gate electrode of the first transistor T1.

Some of the first to seventh transistors T1, T2, T3, T4, T5, T6, and T7 may be P-type transistors, and others may be N-type transistors. In an embodiment, the first, second, fifth, sixth, and seventh transistors T1, T2, T5, T6, and T7 may be P-type transistors, and the third and fourth transistors T3 and T4 may be N-type transistors, for example.

The configuration of the pixel circuit PDC according to this inventive concept is not limited to the embodiment illustrated in FIG. 4. The pixel circuit PDC illustrated in FIG. 4 is only an example, and the configuration of the pixel circuit PDC may be modified. In an embodiment, all of the first to seventh transistors T1, T2, T3, T4, T5, T6, and T7 may be P-type transistors or N-type transistors, for example. In an alternative embodiment, the first, second, fifth, and sixth transistors T1, T2, T5, and T6 may be P-type transistors, and the third, fourth, and seventh transistors T3, T4, and T7 may be N-type transistors.

The j-th initialization scan line GILj, the j-th compensation scan line GCLj, the j-th write scan line GWLj, the j-th black scan line GBLj, and the j-th light-emitting control line ECLj may respectively transmit, to the pixel PXij, a j-th initialization scan signal GIj, a j-th compensation scan signal GCj, a j-th write scan signal GWj, a j-th black scan signal GBj, and a j-th light-emitting control signal EMj. The i-th data line DLi transmits an i-th data signal Di to the pixel PXij. The i-th data signal Di may have a voltage level corresponding to an image signal input to the display device DS (refer to FIG. 1A).

The first and second driving voltage lines VL1 and VL2 may respectively transmit a first driving voltage ELVDD and a second driving voltage ELVSS to the pixel PXij. In addition, the first and second initialization voltage lines VL3 and VL4 may transmit a first initialization voltage VINT and a second initialization voltage VAINT to the pixel PXij.

The first transistor T1 is connected between the light-emitting element ED and the first driving voltage line VL1 which receives the first driving voltage ELVDD. The first transistor T1 includes a first electrode connected to the first driving voltage line VL1 via the fifth transistor T5, a second electrode connected to a pixel electrode (or referred to as an anode) of the light-emitting element ED via the sixth transistor T6, and a third electrode (e.g., a gate electrode) connected to one end (e.g., a first node N1) of the first capacitor Cst. The first transistor T1 may receive the i-th data signal Di transmitted from the i-th data line DLi according to the switching operation of the second transistor T2 to supply a driving current to the light-emitting element ED.

The second transistor T2 is connected between the data line DLi and the first electrode of the first transistor T1. The second transistor T2 includes a first electrode connected to the data line DLi, a second electrode connected to the first electrode of the first transistor T1, and a third electrode (e.g., a gate electrode) connected to the j-th write scan line GWLj. The second transistor T2 may be turned on according to the write scan signal GWj received through the j-th write scan line GWLj and transmit the i-th data signal Di, which is received from the i-th data line DLi, to the first electrode of the first transistor T1. One end of the second capacitor Cbst may be connected to the third electrode of the second transistor T2, and the other end of the second capacitor Cbst may be connected to the first node N1.

The third transistor T3 is connected between the second electrode of the first transistor T1 and the first node N1. The third transistor T3 includes a first electrode connected to the third electrode of the first transistor T1, a second electrode connected to the second electrode of the first transistor T1, and a third electrode (e.g., a gate electrode) connected to the j-th compensation scan line GCLj. The third transistor T3 may be turned on according to the j-th compensation scan signal GCj received through the j-th compensation scan line GCLj so that the third electrode of the first transistor T1 and the second electrode of the first transistor T1 are connected to each other, thus being able to diode-connect the first transistor T1. One end of the third capacitor Nbst may be connected to the third electrode of the third transistor T3, and the other end of the third capacitor Nbst may be connected to the first node N1.

The fourth transistor T4 is connected between the first node N1 and the first initialization voltage line VL3 to which the first initialization voltage VINT is applied. The fourth transistor T4 includes a first electrode connected to the first initialization voltage line VL3 to which the first initialization voltage VINT is transmitted, a second electrode connected to the first node N1, and a third electrode (e.g., a gate electrode) connected to the j-th initialization scan line GILj. The fourth transistor T4 is turned on according to the j-th initialization scan signal GIj received through the j-th initialization scan line GILj. The turned-on fourth transistor T4 transmits the first initialization voltage VINT to the first node N1 to initialize the potential (i.e., the potential of the first node N1) of the third electrode of the first transistor T1.

The fifth transistor T5 includes a first electrode connected to the first driving voltage line VL1, a second electrode connected to the first electrode of the first transistor T1, and a third electrode (e.g., a gate electrode) connected to the j-th light-emitting control line ECLj. The sixth transistor T6 includes a first electrode connected to the second electrode of the first transistor T1, a second electrode connected to the pixel electrode of the light-emitting element ED, and a third electrode (e.g., a gate electrode) connected to the j-th light-emitting control line ECLj.

The fifth and sixth transistors T5 and T6 are simultaneously turned on according to the j-th light-emitting control signal EMj received through the j-th light-emitting control line ECLj. The first driving voltage ELVDD applied through the turned-on fifth transistor T5 may be compensated through the diode-connected first transistor T1 and then transmitted to the light-emitting element ED through the sixth transistor T6.

The seventh transistor T7 includes a first electrode connected to the second initialization voltage line VL4 to which the second initialization voltage VAINT is transmitted, a second electrode connected to a node N2 connected to the second electrode of the sixth transistor T6 and the light-emitting element ED, and a third electrode (e.g., a gate electrode) connected to the black scan line GBLj. The second initialization voltage VAINT may have a voltage level equal to or lower than that of the first initialization voltage VINT.

One end of the first capacitor Cst is connected to the third electrode of the first transistor T1, and the other end of the first capacitor Cst is connected to the first driving voltage line VL1. The cathode of the light-emitting element ED may be connected to the second driving voltage line VL2 which transmits the second driving voltage ELVSS. The second driving voltage ELVSS may have a lower voltage level than that of the first driving voltage ELVDD.

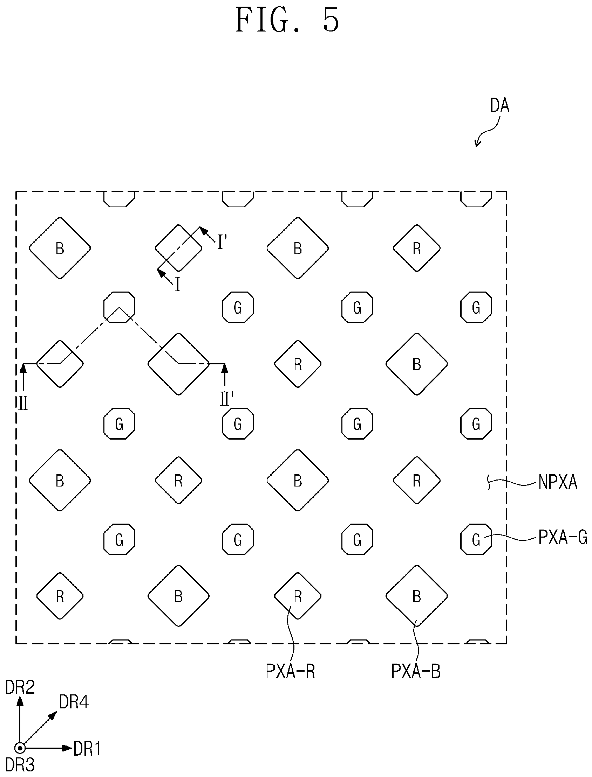

FIG. 5 is an enlarged plan view of an embodiment of a portion of a display region of the display panel according to the inventive concept. FIG. 5 illustrates a plane of the display module DM viewed from the display surface IS (refer to FIG. 1B) of the display module DM (refer to FIG. 1B) and shows an arrangement of the light-emitting regions PXA-R, PXA-G, and PXA-B.

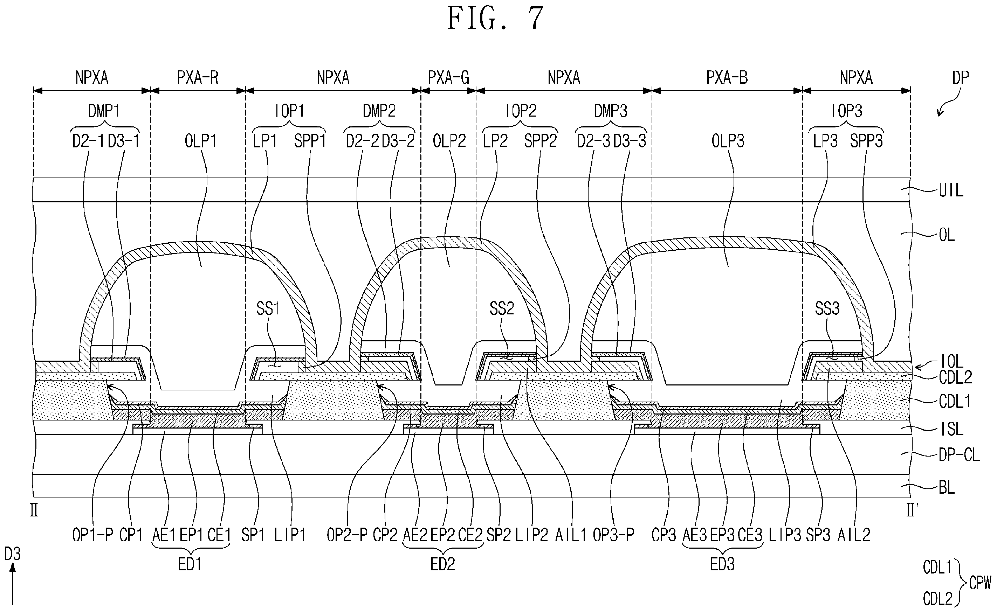

Referring to FIG. 5, the display region DA may include first to third light-emitting regions PXA-R, PXA-G, and PXA-B and a peripheral region NPXA surrounding the first to third light-emitting regions PXA-R, PXA-G, and PXA-B. The first to third light-emitting regions PXA-R, PXA-G, and PXA-B may respectively correspond to regions from which light provided from light-emitting elements ED1, ED2, and ED3 (refer to FIG. 7) is emitted. The first to third light-emitting regions PXA-R, PXA-G, and PXA-B may be classified according to the color of light emitted toward the outside of the display module DM (refer to FIG. 2).

The first to third light-emitting regions PXA-R, PXA-G, and PXA-B may respectively provide first to third color lights having different colors. In an embodiment, the first color light may be red light, the second color light may be green light, and the third color light may be blue light, for example. However, the first to third color lights are not necessarily limited to the above examples.

Each of the first to third light-emitting regions PXA-R, PXA-G, and PXA-B may be defined as a region in which the upper surface of the anode is exposed by a light-emitting opening to be described later. The peripheral region NPXA sets boundaries between the first to third light-emitting regions PXA-R, PXA-G, and PXA-B and may prevent color mixing between the first to third light-emitting regions PXA-R, PXA-G, and PXA-B.

Each of the first to third light-emitting regions PXA-R, PXA-G, and PXA-B may be provided in plural and they may be repeatedly arranged in a predetermined arrangement form in the display region DA. In an embodiment, the first and third light-emitting regions PXA-R and PXA-B may be alternately arranged along the first direction DR1 to form a 'first group', for example. The second light-emitting regions PXA-G may be arranged along the first direction DR1 to form a 'second group'. Each of the 'first group' and the 'second group' may be provided in plural, and the 'first groups' and 'second groups' may be alternately arranged along the second direction DR2.

One second light-emitting region PXA-G may be spaced apart from one first light-emitting region PXA-R or one third light-emitting region PXA-B in a fourth direction DR4. The fourth direction DR4 may be defined as a direction between the first and second directions DR1 and DR2.

FIG. 5 illustrates an arrangement form of the first to third light-emitting regions PXA-R, PXA-G, and PXA-B, but the arrangement form thereof is not limited thereto and they may be arranged in various forms. In an embodiment of the inventive concept, the first to third light-emitting regions PXA-R, PXA-G, and PXA-B may have a PENTILE^{™} arrangement form as illustrated in FIG. 5. In an alternative embodiment, the first to third light-emitting regions PXA-R, PXA-G, and PXA-B may have a stripe arrangement form or a Diamond Pixel^{™} arrangement form.

The first to third light-emitting regions PXA-R, PXA-G, and PXA-B may have various shapes in a plan view. In an embodiment, the first to third light-emitting regions PXA-R, PXA-G, and PXA-B may have polygonal, circular, or elliptical shapes. FIG. 5 illustrates, in a plan view, the first and third light-emitting regions PXA-R and PXA-B having a quadrangular shape (or a diamond shape) and the second light-emitting region PXA-G having an octagonal shape.

The first to third light-emitting regions PXA-R, PXA-G, and PXA-B may have a same shape as each other in a plan view, or at least some of them may have different shapes. FIG. 5 illustrates, in a plan view, the first and third light-emitting regions PXA-R and PXA-B having a same shape as each other and the second light-emitting region PXA-G having a shape different from those of the first and third light-emitting regions PXA-R and PXA-B.

At least some of the first to third light-emitting regions PXA-R, PXA-G, and PXA-B may have different areas in a plan view. In an embodiment of the inventive concept, the area of the first light-emitting region PXA-R which emits red light may be larger than the area of the second light-emitting region PXA-G which emits green light and smaller than the area of the third light-emitting region PXA-B which emits blue light. However, the size relationship between the areas of the first to third light-emitting regions PXA-R, PXA-G, and PXA-B according to the color of emitted light is not limited thereto and may vary depending on the design of the display module DM (refer to FIG. 2). In addition, without being limited thereto, the first to third light-emitting regions PXA-R, PXA-G, and PXA-B may have a same area in a plan view.

The shape, area, and arrangement of the first to third light-emitting regions PXA-R, PXA-G, and PXA-B of the display module DM (refer to FIG. 2) according to this inventive concept may be designed in various ways according to the color of emitted light or the size and configuration of the display module DM (refer to FIG. 2), and the inventive concept is not limited to the embodiment illustrated in FIG. 5.

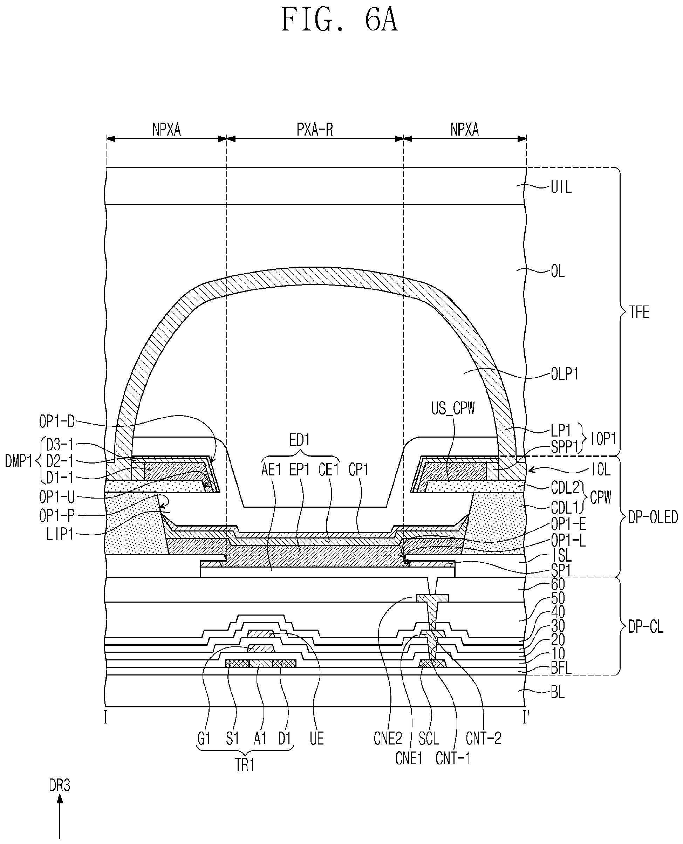

FIG. 6A is a cross-sectional view of an embodiment of the display panel according to the inventive concept. FIG. 6A illustrates a cross section taken along line I-I' of FIG. 5. FIG. 6A will be described with reference to FIG. 2, and the descriptions of the same reference numerals will be omitted.

FIG. 6A is an enlarged view of one first light-emitting region PXA-R in the display region DA (refer to FIG. 5), and FIG. 6A illustrates the shape of the first light-emitting region PXA-R, but a similar description may be applied to the second light-emitting region PXA-G and the third light-emitting region PXA-B.

Referring to FIG. 6A, the display panel DP may include a base layer BL, a circuit element layer DP-CL, a display element layer DP-OLED, and a thin film encapsulation layer TFE.

The display panel DP may include a plurality of insulating layers, a semiconductor pattern, a conductive pattern, a signal line, or the like. An insulating layer, a semiconductor layer, and a conductive layer are formed by a method such as coating, deposition, or the like. Hereafter, the insulating layer, the semiconductor layer, and the conductive layer may be selectively patterned through photolithography and etching processes. In this way, the semiconductor pattern, the conductive pattern, the signal line, or the like included in the circuit element layer DP-CL and the display element layer DP-OLED may be formed.

The circuit element layer DP-CL may be disposed on the base layer BL. The circuit element layer DP-CL may include a buffer layer BFL, a transistor TR1, a signal transmission region SCL, first to fifth insulating layers 10, 20, 30, 40, and 50, an upper electrode UE, and a plurality of connection electrodes CNE1 and CNE2.

The buffer layer BFL may be disposed on the base layer BL. The buffer layer BFL may improve bonding strength between the base layer BL and the semiconductor pattern. The buffer layer BFL may include a silicon oxide layer and a silicon nitride layer. The silicon oxide layer and the silicon nitride layer may be alternately stacked on each other.

The semiconductor pattern may be disposed on the buffer layer BFL. The semiconductor pattern may include or consist of polysilicon. Without being limited thereto, however, the semiconductor pattern may include or consist of amorphous silicon or metal oxide. FIG. 6A illustrates only a portion of the semiconductor pattern, and the semiconductor pattern may be further disposed in the plurality of light-emitting regions PXA-R, PXA-G, and PXA-B (refer to FIG. 5). The semiconductor pattern may be arranged in a predetermined rule across the plurality of light-emitting regions PXA-R, PXA-G, and PXA-B. The semiconductor pattern may have different electrical properties depending on whether it is doped or not. The semiconductor pattern may include a first region having a relatively high doping concentration and a second region having a relatively low doping concentration. The first region may be doped with an N-type dopant or a P-type dopant. A P-type transistor may include the first region doped with a P-type dopant.

The first region has higher conductivity than the second region and substantially serves as an electrode or signal line. The second region may substantially correspond to an active (or channel) of a transistor. In other words, a portion of the semiconductor pattern may be an active of a transistor, another portion thereof may be a source or drain of a transistor, and still another portion thereof may be a conductive region.

A source S1, an active A1, and a drain D1 of the transistor TR1 may be formed from the semiconductor pattern. FIG. 6A illustrates a portion of the signal transmission region SCL formed from the semiconductor pattern. Although not separately illustrated, the signal transmission region SCL may be connected to the drain D1 of the transistor TR1 in a plan view.

The first to fifth insulating layers 10, 20, 30, 40, and 50 may be disposed above the buffer layer BFL. The first to fifth insulating layers 10, 20, 30, 40, and 50 may be inorganic layers or organic layers.

The first insulating layer 10 may be disposed on the buffer layer BFL. The first insulating layer 10 may cover the source S1, active A1, and drain D1 of the transistor T1 and the signal transmission region SCL which are disposed on the buffer layer BFL. A gate G1 of the transistor TR1 may be disposed on the first insulating layer 10. The second insulating layer 20 may be disposed on the first insulating layer 10 to cover the gate G1. The upper electrode UE may be disposed on the second insulating layer 20. The third insulating layer 30 may be disposed on the second insulating layer 20 to cover the upper electrode UE.

A first connection electrode CNE1 may be disposed on the third insulating layer 30. The first connection electrode CNE1 may be connected to the signal transmission region SCL through a contact hole CNT-1 passing through the first to third insulating layers 10, 20, and 30. The fourth insulating layer 40 may be disposed on the third insulating layer 30 to cover the first connection electrode CNE1. The fourth insulating layer 40 may be an organic layer.

A second connection electrode CNE2 may be disposed on the fourth insulating layer 40. The second connection electrode CNE2 may be connected to the first connection electrode CNE1 through a contact hole CNT-2 passing through the fourth insulating layer 40. The fifth insulating layer 50 may be disposed on the fourth insulating layer 40 to cover the second connection electrode CNE2. The fifth insulating layer 50 may be an organic layer.

The display element layer DP-OLED may be disposed on the circuit element layer DP-CL. The display element layer DP-OLED may include a light-emitting element ED1, a sacrificial pattern SP1, a pixel defining film ISL, a bank layer CPW, and dummy patterns DMP1.

The light-emitting element ED1 does include an anode AE1 (or first electrode), a light-emitting pattern EP1, and a cathode CE1 (or second electrode). Each of the first to third light-emitting elements ED1, ED2, and ED3 to be described later do have substantially the same configuration as the light-emitting element ED1 of FIG. 6A. The descriptions of the anode AE1, the light-emitting pattern EP1, and the cathode CE1 may be equally applied to all of the anode, the light-emitting pattern, and the cathode of each of the first to third light-emitting elements to be described later.

The anode AE1 may be disposed on the fifth insulating layer 50 of the circuit element layer DP-CL. The anode AE1 may be a transmissive electrode, a semitransmissive electrode, or a reflective electrode. The anode AE1 may be connected to the second connection electrode CNE2 through a connection contact hole defined to pass through the fifth insulating layer 50. Accordingly, the anode AE1 may be electrically connected to the signal transmission region SCL through the first and second connection electrodes CNE1 and CNE2 so as to be electrically connected to a corresponding circuit element. The anode AE1 may have a single-layered or multi-layered structure. The anode AE1 may include a plurality of layers including or consisting of indium tin oxide ("ITO") and Ag. In an embodiment, the anode AE1 may include a layer (hereinafter referred to as a lower ITO layer) including or consisting of ITO, a layer (hereinafter referred to as an Ag layer) disposed on the lower ITO layer and including or consisting of Ag, and a layer (hereinafter referred to as an upper ITO layer) disposed on the Ag layer and including or consisting of ITO, for example.

The sacrificial pattern SP1 may be disposed between the anode AE1 and the pixel defining film ISL. The sacrificial pattern SP1 may correspond to a portion of a layer provided to prevent the anode AE1 from being damaged in a process of forming a pixel opening OP1-P which will be described later. A sacrificial opening OP1-L which exposes a portion of the upper surface of the anode AE1 may be defined in the sacrificial pattern SP1. The sacrificial opening OP1-L may overlap a light-emitting opening OP1-E which will be described later. The sacrificial pattern SP1 may include or consist of amorphous transparent conductive oxide. In an embodiment, the sacrificial pattern SP1 may include or consist of zinc oxide (ZnOₓ) doped with aluminium (Al), for example.

The pixel defining film ISL may be disposed on the fifth insulating layer 50 of the circuit element layer DP-CL. The light-emitting opening OP1-E may be defined in the pixel defining film ISL. The light-emitting opening OP1-E may correspond to the anode AE1, and the pixel defining film ISL may expose at least a portion of the anode AE1 through the light-emitting opening OP1-E.

In addition, the light-emitting opening OP1-E may correspond to the sacrificial opening OP1-L of the sacrificial pattern SP1. According to this embodiment, the upper surface of the anode AE1 may be spaced apart from the pixel defining film ISL on a cross section with the sacrificial pattern SP1 interposed therebetween, and accordingly, in a process of forming the light-emitting opening OP1-E, damage to the anode AE1 may be prevented.

On a plane, the area of the light-emitting opening OP1-E may be smaller than that of the sacrificial opening OP1-L. That is, an inner side surface of the pixel defining film ISL defining the light-emitting opening OP1-E may be closer to the center of the anode AE1 than an inner side surface of the sacrificial pattern SP1 defining the sacrificial opening OP1-L. Without being limited thereto, however, the inner side surface of the sacrificial pattern SP1 defining the sacrificial opening OP1-L may be substantially aligned with the inner side surface of the pixel defining film ISL defining a corresponding light-emitting opening OP1-E. In this case, the first light-emitting region PXA-R may be regarded as a region of the anode AE1 exposed from a corresponding sacrificial opening OP1-L.

The pixel defining film ISL may include or consist of an inorganic insulating material. The pixel defining film ISL may include or consist of at least any one of silicon oxide (SiOₓ), silicon nitride (SiNₓ), or silicon oxynitride (SiOₓN_{y}). In an embodiment, silicon nitride (SiNₓ) may be contained therein, for example. The pixel defining film ISL may be disposed between the anode AE1 and the bank layer CPW to block electrical connection between the anode AE1 and the bank layer CPW.

The bank layer CPW is disposed on the pixel defining film ISL.
A pixel opening OP1-P may be defined in the bank layer CPW. The pixel opening OP1-P may correspond to the light-emitting opening OP1-E and may expose at least a portion of the anode AE1.

The bank layer CPW may have an undercut shape on a cross section. The bank layer CPW may include a plurality of layers sequentially stacked on each other, and at least one of the plurality of layers may be recessed compared to other layers. At least one of the plurality of layers included in the bank layer CPW may protrude compared to the other layers. Accordingly, the bank layer CPW may include a tip portion.

In this embodiment, the bank layer CPW may include a first conductive layer CDL1 and a second conductive layer CDL2. Each of the first conductive layer CDL1 and the second conductive layer CDL2 may include or consist of a conductive material. The first conductive layer CDL1 may be disposed on the pixel defining film ISL and have a first conductivity and a first thickness. The second conductive layer CDL2 may be disposed on the first conductive layer CDL1, have a second conductivity lower than the first conductivity, and have a second thickness smaller than the first thickness.

An etch rate of the first conductive layer CDL1 may be higher than an etch rate of the second conductive layer CDL2. That is, the first conductive layer CDL1 may include or consist of a material having a higher etching selectivity than the second conductive layer CDL2.

In an embodiment of the inventive concept, each of the first and second conductive layers CDL1 and CDL2 may include or consist of a metal material. In addition, in an embodiment of the inventive concept, the second conductive layer CDL2 may include or consist of a material having a lower reflectance than the first conductive layer CDL1 and reduce reflectance on the upper surface of the second conductive layer CDL2 which substantially forms an upper surface US_CPW of the bank layer CPW, thus being able to improve the display quality of the display panel DP. In an embodiment, the first conductive layer CDL1 may include or consist of aluminium (Al), and the second conductive layer CDL2 may include or consist of titanium (Ti), for example. However, the materials of the first and second conductive layers CDL1 and CDL2 are not limited to any particular embodiment.

In this embodiment, the bank layer CPW may receive a bias voltage. Accordingly, the bias voltage may be provided to the cathode CE1 in contact with the bank layer CPW.

In this embodiment, in a plan view, a first upper opening OP1-U defined in the second conductive layer CDL2 may overlap a first upper opening OP1-U defined in the first conductive layer CDL1, and the area of the first upper opening OP1-U defined in the second conductive layer CDL2 may be smaller than the area of the first upper opening OP1-U defined in the first conductive layer CDL1.

As illustrated in FIG. 6A, on a cross section, the second conductive layer CDL2 may have an undercut shape protruding more than the first conductive layer CDL1. On a cross section, the inner side surface of the second conductive layer CDL2 may be closer to the center of the anode AE1 than the inner side surface of the first conductive layer CDL1. That is, a region defined by the inner side surface of the second conductive layer CDL2 may have a smaller width in one direction than a region defined by the inner side surface of the first conductive layer CDL1. In this inventive concept, in the bank layer CPW, a protruding portion of the second conductive layer CDL2 closer to the center of the anode AE1 than the inner side surface of the first conductive layer CDL1 may be defined as a tip portion.

In an embodiment of the inventive concept, the area defined by the inner side surface of the first conductive layer CDL1 in a plan view may be greater than the area of the first light-emitting opening OP1-E defined in the pixel defining film ISL, and the first conductive layer CDL1 may expose a portion of the upper surface of the pixel defining film ISL.

The thickness of the first conductive layer CDL1 may be, e.g., about 4000 angstroms to about 7000 angstroms. The thickness of the second conductive layer CDL2 may be smaller than that of the first conductive layer CDL1. In an embodiment, the thickness of the second conductive layer CDL2 may be about 500 angstroms to about 1000 angstroms, for example.

FIG. 6A illustrates that the side surface of the bank layer CPW has a tapered shape with respect to the upper surface of the pixel defining film ISL, but the embodiment of the inventive concept is not limited thereto. In an embodiment, the bank layer CPW may have a vertically extending sidewall or have a reverse-tapered shape, for example.

The light-emitting pattern EP1 are disposed on the anode AE1. The light-emitting pattern EP1 may include a light-emitting layer including or consisting of a light-emitting material. The light-emitting pattern EP1 may further include a hole injection layer and a hole transport layer, which are disposed between the anode AE1 and the light-emitting layer, and may further include an electron transport layer and an electron injection layer disposed on the light-emitting layer. The light-emitting pattern EP1 may also be referred to as an 'organic layer' or an 'intermediate layer'.

The light-emitting pattern EP1 may be patterned by the tip portion defined in the bank layer CPW. The light-emitting pattern EP1 may be disposed inside the sacrificial opening OP1-L, the light-emitting opening OP1-E, and the pixel opening OP1-P. The light-emitting pattern EP1 may cover a portion of the upper surface of the pixel defining film ISL exposed through the pixel opening OP1-P.

The cathode CE1 may be disposed on the light-emitting pattern EP1. The cathode CE1 may be patterned by the tip portion defined in the bank layer CPW. The cathode CE1 may contact the inner side surface of the first conductive layer CDL1 of the bank layer CPW.

The bank layer CPW may receive the second driving voltage ELVSS (refer to FIG. 3B), and accordingly, the cathode CE1 may be electrically connected to the bank layer CPW and receive the second driving voltage ELVSS (refer to FIG. 3B).

In an embodiment of the inventive concept, the display panel DP may further include a capping pattern CP1. The capping pattern CP1 may be disposed in the pixel opening OP1-P and may be disposed on the cathode CE1. The capping pattern CP1 may be patterned by the tip portion formed in the bank layer CPW.

FIG. 6A illustrates that the capping pattern CP1 does not contact the inner side surface of the bank layer CPW, but the embodiment of the inventive concept is not limited thereto. In an embodiment, the capping pattern CP1 may be formed to contact the inner side surface of the bank layer CPW, for example. In another embodiment of the inventive concept, the capping pattern CP1 may be omitted.

The dummy patterns DMP1 may be disposed on the bank layer CPW. The dummy patterns DMP1 may include a first layer dummy pattern D1-1, a second layer dummy pattern D2-1, and a third layer dummy pattern D3-1. The first to third layer dummy patterns D1-1, D2-1, and D3-1 are sequentially stacked on the upper surface of the second conductive layer CDL2 of the bank layer CPW along the third direction DR3.

The first layer dummy pattern D1-1 may include or consist of an organic material. In an embodiment, the first layer dummy pattern D1-1 may include or consist of the same material as that of the light-emitting pattern EP1, for example. The first layer dummy pattern D1-1 may be formed simultaneously with the light-emitting pattern EP1 through one process and may be formed separately from the light-emitting pattern EP1 by the undercut shape of the bank layer CPW.

The second layer dummy pattern D2-1 may include or consist of a conductive material. In an embodiment, the second layer dummy pattern D2-1 may include or consist of the same material as that of the cathode CE1, for example. The second layer dummy pattern D2-1 may be formed simultaneously with the cathode CE1 through one process and may be formed separately from the cathode CE1 by the undercut shape of the bank layer CPW.

The third layer dummy pattern D3-1 may include or consist of the same material as that of the capping pattern CP1. The third layer dummy pattern D3-1 may be formed simultaneously with the capping pattern CP1 through one process and may be formed separately from the capping pattern CP1 by the undercut shape of the bank layer CPW.

A dummy opening OP1-D may be defined in the dummy patterns DMP1. The dummy opening OP1-D may correspond to the light-emitting opening OP1-E. On a plane, each of the first to third layer dummy patterns D1-1, D2-1, and D3-1 may have a closed line shape surrounding the first light-emitting region PXA-R.

FIG. 6A illustrates that the inner side surfaces of the first to third layer dummy patterns D1-1, D2-1, and D3-1 protrude more than the inner side surface of the second conductive layer CDL2 and cover the same, but the embodiment of the inventive concept is not limited thereto, and the inner side surfaces of the first to third layer dummy patterns D1-1, D2-1, and D3-1 may be aligned with the inner side surface of the second conductive layer CDL2.

The display panel DP further includes a thin film encapsulation layer TFE. The thin film encapsulation layer TFE may be disposed on the display element layer DP-OLED. The thin film encapsulation layer TFE may include an inorganic encapsulation pattern LIP1, an organic pattern OLP1, an inorganic film IOL, an encapsulation organic film OL, and an upper encapsulation inorganic film UIL.

A portion of the inorganic encapsulation pattern LIP1 may be disposed to correspond to the pixel opening OP1-P. The inorganic encapsulation pattern LIP1 may be disposed on the cathode CE1 of the light-emitting element ED1, cover the cathode CE1 and the dummy patterns DMP1, and be partially disposed inside the pixel opening OP1-P. In an embodiment of the inventive concept, the inorganic encapsulation pattern LIP1 may cover the inner side surface of the first conductive layer CDL1, the inner side surface of the second conductive layer CDL2, and the upper surfaces of the dummy patterns DMP1. The inorganic encapsulation pattern LIP1 may be disposed directly on the cathode CE1 and the dummy patterns DMP1. The inorganic encapsulation pattern LIP1 may cover the third layer dummy pattern D3-1 disposed at the uppermost portion of the dummy patterns DMP1. A portion of the inorganic encapsulation pattern LIP1 may be disposed on a portion of the bank layer CPW in which the dummy pattern DMP1 is not disposed, and a portion of an inorganic film IOL to be described later may be disposed between the inorganic encapsulation pattern LIP1 and the bank layer CPW.

The organic pattern OLP1 is disposed on the inorganic encapsulation pattern LIP1. The organic pattern OLP1 may be disposed on the inorganic encapsulation pattern LIP1 so as to have a relatively large thickness and may be patterned on the inorganic encapsulation pattern LIP1 so as to have a rounded upper surface. The organic pattern OLP1 may be disposed to overlap at least the first light-emitting region PXA-R. The organic pattern OLP1 may be disposed to correspond to the pixel opening OP1-P. The organic pattern OLP1 may be disposed to cover an entirety of the inorganic encapsulation pattern LIP1 in a plan view. That is, the organic pattern OLP1 may be disposed only on a portion in which the inorganic encapsulation pattern LIP1 is disposed based on the third direction DR3.

The inorganic film IOL is disposed on the organic pattern OLP1. The inorganic film IOL is disposed on the organic pattern OLP1 to cover an entirety of the upper surface of the organic pattern OLP1. The inorganic film IOL may cover the upper portion of the organic pattern OLP1 and extend to a portion in which the bank layer CPW is disposed.

The inorganic film IOL does include a spacer portion SPP1 and a layer portion LP1. As described above, the spacer portion SPP1 does correspond to a portion of the inorganic film IOL disposed between the inorganic encapsulation pattern LIP1 and the bank layer CPW. That is, a predetermined space is disposed between the inorganic encapsulation pattern LIP1 and the bank layer CPW, and the spacer portion SPP1 of the inorganic film IOL may be disposed in the predetermined space. The spacer portion SPP1 is disposed to contact the dummy pattern DMP1. The spacer portion SPP1 may contact the inorganic encapsulation pattern LIP1 and the second conductive layer CDL2 and may contact at least one of the first layer dummy pattern D1-1 or the second layer dummy pattern D2-1 among the dummy patterns DMP1.

The layer portion LP1 may cover the upper portion of the organic pattern OLP1 and may be disposed to cover a portion of the upper portion of the bank layer CPW. The layer portion LP1 and the spacer portion SPP1 may have a shape in which they are separated from each other. That is, an interface may exist between the layer portion LP1 and the spacer portion SPP1, and the layer portion LP1 and the spacer portion SPP1 may not have an integral shape. Since the layer portion LP1 and the spacer portion SPP1 are formed through different processes, the layer portion LP1 and the spacer portion SPP1 may have a shape in which they are separated from each other.

The encapsulation organic film OL may cover the inorganic film IOL and provide a flat upper surface. The upper encapsulation inorganic film UIL may be disposed on the encapsulation organic film OL.

The inorganic encapsulation pattern LIP1, the inorganic film IOL, and the upper encapsulation inorganic film UIL may protect the display element layer DP-OLED from moisture/oxygen, and the organic pattern OLP1 and the encapsulation organic film OL may protect the display element layer DP-OLED from foreign substances such as dust particles. The inorganic encapsulation pattern LIP1, the inorganic film IOL, and the upper encapsulation inorganic film UIL may include or consist of silicon nitride, silicon oxynitride, silicon oxide, titanium oxide, aluminium oxide, or the like, but the embodiment of the inventive concept is not particularly limited thereto. The organic pattern OLP1 and the encapsulation organic film OL may include or consist of an acryl-based compound, an epoxy-based compound, or the like. The organic pattern OLP1 and the encapsulation organic film OL may include or consist of a photopolymerizable organic material, and the embodiment of the inventive concept is not particularly limited thereto.

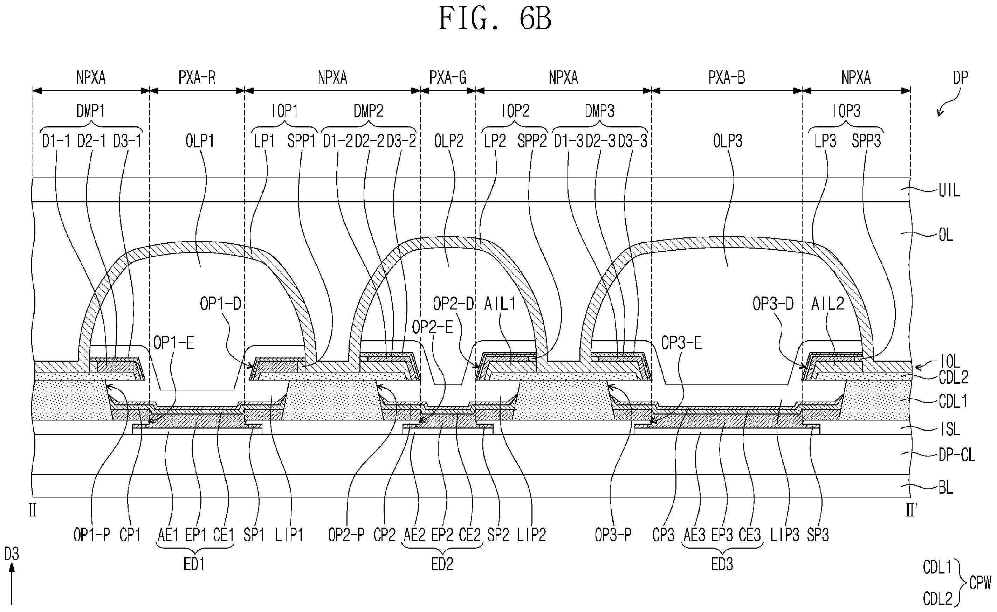

FIG. 6B is a cross-sectional view of an embodiment of the display panel according to the inventive concept. FIG. 6B is a cross-sectional view taken along line II-II' of FIG. 5. FIG. 6B is an enlarged view of one first light-emitting region PXA-R, one second light-emitting region PXA-G, and one third light-emitting region PXA-B. The description of the first light-emitting region PXA-R may be equally applied to each of the first to third light-emitting regions PXA-R, PXA-G, and PXA-B.

Referring to FIG. 6B, the display panel DP according to this embodiment may include a base layer BL, a circuit element layer DP-CL, a display element layer DP-OLED, and a thin film encapsulation layer TFE. The display element layer DP-OLED may include light-emitting elements ED1, ED2, and ED3, sacrificial patterns SP1, SP2, and SP3, a pixel defining film ISL, a bank layer CPW, and dummy patterns DMP1, DMP2, and DMP3. The thin film encapsulation layer TFE may include inorganic encapsulation patterns LIP1, LIP2, and LIP3, organic patterns OLP1, OLP2, and OLP3, an inorganic film IOL, an encapsulation organic film OL, and an upper encapsulation inorganic film UIL.

The light-emitting elements ED1, ED2, and ED3 do include a first light-emitting element ED1, a second light-emitting element ED2, and a third light-emitting element ED3. The first light-emitting element ED1 does include a first anode AE1, a first light-emitting pattern EP1, and a first cathode CE1. The second light-emitting element ED2 does include a second anode AE2, a second light-emitting pattern EP2, and a second cathode CE2. The third light-emitting element ED3 does include a third anode AE3, a third light-emitting pattern EP3, and a third cathode CE3. The first to third anodes AE1, AE2, and AE3 may be provided as a plurality of patterns. In an embodiment of the inventive concept, the first light-emitting pattern EP1 may provide red light, the second light-emitting pattern EP2 may provide green light, and the third light-emitting pattern EP3 may provide blue light.

First to third light-emitting openings OP1-E, OP2-E, and OP3-E are defined in the pixel defining film ISL. The first light-emitting opening OP1-E may expose at least a portion of the first anode AE1. The first light-emitting region PXA-R may be defined as a region exposed through the first light-emitting opening OP1-E among the upper surface of the first anode AE1. The second light-emitting opening OP2-E may expose at least a portion of the second anode AE2. The second light-emitting region PXA-G may be defined as a region exposed through the second light-emitting opening OP2-E among the upper surface of the second anode AE2. The third light-emitting opening OP3-E may expose at least a portion of the third anode AE3. The third light-emitting region PXA-B may be defined as a region exposed through the third light-emitting opening OP3-E among the upper surface of the third anode AE3.

The sacrificial patterns SP1, SP2, and SP3 may include a first sacrificial pattern SP1, a second sacrificial pattern SP2, and a third sacrificial pattern SP3. The first to third sacrificial patterns SP1, SP2, and SP3 may be respectively disposed on the upper surfaces of the first to third anodes AE1, AE2, and AE3. First to third sacrificial openings respectively corresponding to the first to third light-emitting openings OP1-E, OP2-E, and OP3-E may be defined in the first to third sacrificial patterns SP1, SP2, and SP3.

In this embodiment, first to third pixel openings OP1-P, OP2-P, and OP3-P respectively corresponding to the first to third light-emitting openings OP1-E, OP2-E, and OP3-E may be defined in the bank layer CPW.

The first light-emitting pattern EP1 and the first cathode CE1 is disposed in the first pixel opening OP1-P, the second light-emitting pattern EP2 and the second cathode CE2 is disposed in the second pixel opening OP2-P, and the third light-emitting pattern EP3 and the third cathode CE3 is disposed in the third pixel opening OP3-P. The first to third cathodes CE1, CE2, and CE3 respectively contact the inner side surfaces of the first conductive layer CDL1.

In this embodiment, the first to third cathodes CE1, CE2, and CE3 may be physically separated from each other by the second conductive layer CDL2 which forms a tip portion, respectively formed in the light-emitting openings OP1-E, OP2-E, and OP3-E, and electrically connected to each other by coming in contact with the first conductive layer CDL1 so as to be able to receive a common voltage. Since the first conductive layer CDL1, which each of the first to third cathodes CE1, CE2, and CE3 contacts, has relatively higher electrical conductivity than the second conductive layer CDL2, it is possible to reduce the contact resistance of the first to third cathodes CE1, CE2, and CE3. Accordingly, a common cathode voltage may be uniformly provided to the light-emitting regions PXA-R, PXA-G, and PXA-B.

According to this inventive concept, the plurality of light-emitting patterns EP1, EP2, and EP3 may be are patterned and deposited in pixel units by the tip portion defined in the bank layer CPW. That is, the plurality of light-emitting patterns EP1, EP2, and EP3 is commonly formed by an open mask, but may be easily divided into pixel units by the bank layer CPW.

When the plurality of light-emitting patterns EP1, EP2, and EP3 is patterned by a fine metal mask ("FMM"), a support spacer protruding from the conductive barrier rib should be provided to support the fine metal mask. In addition, since the fine metal mask is spaced apart from the base surface, on which patterning is performed, by as much as the height of the barrier rib and the spacer, the implementation of relatively high resolution may be limited. In addition, as the fine metal mask contacts the spacer, foreign substances may remain on the spacer after the patterning process of the plurality of light-emitting patterns EP1, EP2, and EP3, or the spacer may be damaged by being nicked by the fine metal mask. Accordingly, a defective display panel may be formed.

According to this embodiment, by including the bank layer CPW, physical separation between the light-emitting elements ED1, ED2, and ED3 may be easily achieved. Accordingly, a current leakage or a driving error between adjacent light-emitting regions PXA-R, PXA-G, and PXA-B may be prevented, and it is possible to drive each of the light-emitting elements ED1, ED2, and ED3 independently.

In particular, by patterning the plurality of light-emitting patterns EP1, EP2, and EP3 without a mask in contact with internal components in the display region DA (refer to FIG. 1B), the defect rate may be reduced, thus making it possible to provide the display panel DP having improved process reliability. Since patterning is possible even when a separate support spacer protruding from the back layer CPW is not provided, the area of the light-emitting regions PXA-R, PXA-G, and PXA-B may be minimized and therefore, it is possible to provide the display panel DP that easily implements relatively high resolution.

In addition, in manufacturing the display panel DP having a relatively large area, a process cost may be reduced by omitting the manufacture of a mask having a relatively large area, and by not being affected by a defect which may occur in a large-area mask, it is possible to provide the display panel DP having improved process reliability.

Capping patterns CP1, CP2, and CP3 may include a first capping pattern CP1, a second capping pattern CP2, and a third capping pattern CP3. The first to third capping patterns CP1, CP2, and CP3 may be respectively disposed on the first to third cathodes CE1, CE2, and CE3 and may be disposed on the first to third pixel openings OP1-P, OP2-P, and OP3-P.

The dummy patterns DMP1, DMP2, and DMP3 do include a plurality of first dummy patterns DMP1, a plurality of second dummy patterns DMP2, and a plurality of third dummy patterns DMP3. The first dummy patterns DMP1, the second dummy patterns DMP2, and the third dummy patterns DMP3 respectively include first layer dummy patterns D1-1, D1-2, and D1-3, second layer dummy patterns D2-1, D2-2, and D2-3, and third layer dummy patterns D3-1, D3-2, and D3-3.

The first dummy patterns DMP1 may include (1-1)-th to (3-1)-th layer dummy patterns D1-1, D2-1, and D3-1 surrounding the first light-emitting region PXA-R in a plan view. The (1-1)-th layer dummy patterns D1-1 may include or consist of the same material as that of the first light-emitting pattern EP1 and may be formed through the same process as the first light-emitting pattern EP1. The (2-1)-th layer dummy patterns D2-1 may include or consist of the same material as that of the first cathode CE1 and may be formed through the same process as the first cathode CE1. The (3-1)-th layer dummy patterns D3-1 may include or consist of the same material as that of the first capping pattern CP1 and may be formed through the same process as the first capping pattern CP1.

The second dummy patterns DMP2 may include (1-2)-th to (3-2)-th layer dummy patterns D1-2, D2-2, and D3-2 surrounding the second light-emitting region PXA-G in a plan view. The (1-2)-th layer dummy patterns D1-2 may include or consist of the same material as that of the second light-emitting pattern EP2 and may be formed through the same process as the second light-emitting pattern EP2. The (2-2)-th layer dummy patterns D2-2 may include or consist of the same material as that of the second cathode CE2 and may be formed through the same process as the second cathode CE2. The (3-2)-th layer dummy patterns D3-2 may include or consist of the same material as that of the second capping pattern CP2 and may be formed through the same process as the second capping pattern CP2.

The third dummy patterns DMP3 may include (1-3)-th to (3-3)-th layer dummy patterns D1-3, D2-3, and D3-3 surrounding the third light-emitting region PXA-B in a plan view. The (1-3)-th layer dummy patterns D1-3 may include or consist of the same material as that of the third light-emitting pattern EP3 and may be formed through the same process as the third light-emitting pattern EP3. The (2-3)-th layer dummy patterns D2-3 may include or consist of the same material as that of the third cathode CE3 and may be formed through the same process as the third cathode CE3. The (3-3)-th layer dummy patterns D3-3 may include or consist of the same material as that of the third capping pattern CP3 and may be formed through the same process as the third capping pattern CP3.

In the dummy patterns DMP1, DMP2, and DMP3, first to third dummy openings OP1-D, OP2-D, and OP3-D respectively corresponding to the first to third light-emitting openings OP1-E, OP2-E, and OP3-E may be defined. The first dummy opening OP1-D may be defined by the inner side surfaces of the (1-1)-th to (3-1)-th layer dummy patterns D1-1, D2-1, and D3-1, the second dummy opening OP2-D may be defined by the inner side surfaces of the (1-2)-th to (3-2)-th layer dummy patterns D1-2, D2-2, and D3-2, and the third dummy opening OP3-D may be defined by the inner side surfaces of the (1-3)-th to (3-3)-th layer dummy patterns D1-3, D2-3, and D3-3.

The thin film encapsulation layer TFE include inorganic encapsulation patterns LIP1, LIP2, and LIP3, organic patterns OLP1, OLP2, and OLP3, an inorganic film IOL, an encapsulation organic film OL, and an upper encapsulation inorganic film UIL.

In this embodiment, the inorganic encapsulation patterns LIP1, LIP2, and LIP3 do include a first inorganic encapsulation pattern LIP1, a second inorganic encapsulation pattern LIP2, and a third inorganic encapsulation pattern LIP3. The first to third inorganic encapsulation patterns LIP1, LIP2, and LIP3 may respectively correspond to the first to third light-emitting openings OP1-E, OP2-E, and OP3-E.

The first inorganic encapsulation pattern LIP1 does cover the first light-emitting element ED1 and the first dummy patterns DMP1 and may be partially disposed inside the first pixel opening OP1-P. The second inorganic encapsulation pattern LIP2 does cover the second light-emitting element ED2 and the second dummy patterns DMP2 and may be partially disposed inside the second pixel opening OP2-P. The third inorganic encapsulation pattern LIP3 does cover the third light-emitting element ED3 and the third dummy patterns DMP3 and may be partially disposed inside the third pixel opening OP3-P. The first to third inorganic encapsulation patterns LIP1, LIP2, and LIP3 may be provided in the form of patterns spaced apart from each other in a plan view. The first to third inorganic encapsulation patterns LIP1, LIP2, and LIP3 are respectively disposed directly on the first to third cathodes CE1, CE2, and CE3 and the first to third dummy patterns DMP1, DMP2, and DMP3. Each of the first to third inorganic encapsulation patterns LIP1, LIP2, and LIP3 are partially disposed on a portion of the bank layer CPW in which the first to third dummy patterns DMP1, DMP2, and DMP3 are not disposed, and a portion of an inorganic film IOL, which will be described later, may be disposed between each of the first to third inorganic encapsulation patterns LIP1, LIP2, and LIP3 and the bank layer CPW.

The first to third organic patterns OLP1, OLP2, and OLP3 are disposed on the first to third inorganic encapsulation patterns LIP1, LIP2, and LIP3. The first organic pattern OLP1 may be disposed on the first inorganic encapsulation pattern LIP1 so as to have a relatively large thickness and may be patterned on the first inorganic encapsulation pattern LIP1 so as to have a rounded upper surface. The first organic pattern OLP1 may be disposed to overlap at least the first light-emitting region PXA-R. The first organic pattern OLP1 may be disposed to correspond to the first pixel opening OP1-P. The first organic pattern OLP1 may be disposed to cover an entirety of the first inorganic encapsulation pattern LIP1 in a plan view. That is, the first organic pattern OLP1 may be disposed only on a portion in which the first inorganic encapsulation pattern LIP1 is disposed based on the third direction DR3. The second organic pattern OLP2 may be disposed on the second inorganic encapsulation pattern LIP2 so as to have a relatively large thickness and may be patterned on the second inorganic encapsulation pattern LIP2 so as to have a rounded upper surface. The second organic pattern OLP2 may be disposed to overlap at least the second light-emitting region PXA-G. The second organic pattern OLP2 may be disposed to correspond to the second pixel opening OP2-P. The second organic pattern OLP2 may be disposed to cover an entirety of the second inorganic encapsulation pattern LIP2 in a plan view. That is, the second organic pattern OLP2 may be disposed only on a portion in which the second inorganic encapsulation pattern LIP2 is disposed based on the third direction DR3. The third organic pattern OLP3 may be disposed on the third inorganic encapsulation pattern LIP3 so as to have a relatively large thickness and may be patterned on the third inorganic encapsulation pattern LIP3 so as to have a rounded upper surface. The third organic pattern OLP3 may be disposed to overlap at least the third light-emitting region PXA-B. The third organic pattern OLP3 may be disposed to correspond to the third pixel opening OP3-P. The third organic pattern OLP3 may be disposed to cover an entirety of the third inorganic encapsulation pattern LIP3 in a plan view. That is, the third organic pattern OLP3 may be disposed only on a portion in which the third inorganic encapsulation pattern LIP3 is disposed based on the third direction DR3. The first to third organic patterns OLP1, OLP2, and OLP3 may be provided in the form of patterns spaced apart from each other in a plan view.

The inorganic film IOL is disposed on the first to third organic patterns OLP1, OLP2, and OLP3. The inorganic film IOL is disposed on the first to third organic patterns OLP1, OLP2, and OLP3 to cover an entirety of the upper surface of each of the first to third organic patterns OLP1, OLP2, and OLP3. The inorganic film IOL does cover the upper portions of the first to third organic patterns OLP1, OLP2, and OLP3 and may extend to a portion in which the bank layer CPW is disposed.

The inorganic film IOL does include a first inorganic portion IOP1 covering the first organic pattern OLP1, a second inorganic portion IOP2 covering the second organic pattern OLP2, and a third inorganic portion IOP3 covering the third organic pattern OLP3.

The first inorganic portion IOP1 does include a first spacer portion SPP1 and a first layer portion LP1. The second inorganic portion IOP2 does a include a second spacer portion SPP2 and a second layer portion LP2. The third inorganic portion IOP3 does include a third spacer portion SPP3 and a third layer portion LP3.
The first spacer portion SPP1 does correspond to a portion of the inorganic film IOL disposed between the first inorganic encapsulation pattern LIP1 and the bank layer CPW. The second spacer portion SPP2 does correspond to a portion of the inorganic film IOL disposed between the second inorganic encapsulation pattern LIP2 and the bank layer CPW. The third spacer portion SPP3 does correspond to a portion of the inorganic film IOL disposed between the third inorganic encapsulation pattern LIP3 and the bank layer CPW. The first to third spacer portions SPP1, SPP2, and SPP3 are respectively disposed to contact the first to third dummy patterns DMP1, DMP2, and DMP3.

The first layer portion LP1 is disposed to cover the upper portion of the first organic pattern OLP1 and a portion of the upper portion of the bank layer CPW. The second layer portion LP2 is disposed to cover the upper portion of the second organic pattern OLP2 and a portion of the upper portion of the bank layer CPW. The third layer portion LP3 is disposed to cover the upper portion of the third organic pattern OLP3 and a portion of the upper portion of the bank layer CPW. The first to third layer portions LP1, LP2, and LP3 do have an integral shape in which the first to third layer portions LP1, LP2, and LP3 are connected to each other on the bank layer CPW.

The first layer portion LP1 and the first spacer portion SPP1 may have a shape in which they are separated from each other. An interface may exist between the first layer portion LP1 and the first spacer portion SPP1, and the first layer portion LP1 and the first spacer portion SPP1 may not have an integral shape. Since the first layer portion LP1 and the first spacer portion SPP1 are formed through different processes, the first layer portion LP1 and the first spacer portion SPP1 may have a shape in which they are separated from each other. The second layer portion LP2 and the second spacer portion SPP2 may have a shape in which they are separated from each other. An interface may exist between the second layer portion LP2 and the second spacer portion SPP2, and the second layer portion LP2 and the second spacer portion SPP2 may not have an integral shape. Since the second layer portion LP2 and the second spacer portion SPP2 are formed through different processes, the second layer portion LP2 and the second spacer portion SPP2 may have a shape in which they are separated from each other.

The third layer portion LP3 and the third spacer portion SPP3 may have an integral shape. A separate interface may not exist between the third layer portion LP3 and the third spacer portion SPP3. The third layer portion LP3 and the third spacer portion SPP3 may be formed through a same process and have an integral shape.

A first additional inorganic pattern AIL1 may be disposed between the second dummy pattern DMP2 and the bank layer CPW. The first additional inorganic pattern AIL1 may be disposed on the second conductive layer CDL2 of the bank layer CPW, and the second dummy pattern DMP2 and the second spacer portion SPP2 may be disposed on the first additional inorganic pattern AIL1. The first additional inorganic pattern AIL1 may be a portion of a preliminary inorganic film, which is formed in one process operation of a method of manufacturing a display panel to be described later and remains without being removed. A second additional inorganic pattern AIL2 may be disposed between the third dummy pattern DMP3 and the bank layer CPW. The second additional inorganic pattern AIL2 may be disposed on the second conductive layer CDL2 of the bank layer CPW, and the third dummy pattern DMP3 and the third spacer portion SPP3 may be disposed on the second additional inorganic pattern AIL2. The second additional inorganic pattern AIL2 may be a portion of a preliminary inorganic film, which is formed in one process operation of a method of manufacturing a display panel to be described later and remains without being removed.

The encapsulation organic film OL may cover the inorganic film IOL and provide a flat upper surface. The upper encapsulation inorganic film UIL may be disposed on the encapsulation organic film OL.

The first to third inorganic encapsulation patterns LIP1, LIP2, and LIP3, the inorganic film IOL, and the upper encapsulation inorganic film UIL may protect the display element layer DP-OLED from moisture/oxygen, and the first to third organic patterns OLP1, OLP2, and OLP3 and the encapsulation organic film OL may protect the display element layer DP-OLED from foreign substances such as dust particles.

In the display panel DP in an embodiment of the inventive concept, the plurality of light-emitting patterns EP1, EP2, and EP3 is easily divided into pixel units by the tip portion defined by the bank layer CPW. The display panel DP has a structure in which the inorganic encapsulation patterns LIP1, LIP2, and LIP3, the organic patterns OLP1, OLP2, and OLP3, and the inorganic film IOL are sequentially stacked on the upper portion of each of the plurality of light-emitting patterns EP1, EP2, and EP3 and has a shape in which the dummy patterns DMP1, DMP2, and DMP3 disposed on the bank layer CPW are also covered by the inorganic encapsulation patterns LIP1, LIP2, and LIP3, the organic patterns OLP1, OLP2, and OLP3, and the inorganic film IOL. Accordingly, compared to a case in which a conventional etching process is performed by a photoresist pattern, the possibility of losing organic material layers included in the dummy patterns DMP1, DMP2, and DMP3 may be reduced, and since the light-emitting patterns EP1, EP2, and EP3 and the dummy patterns DMP1, DMP2, and DMP3 are covered by the thick organic patterns OLP1, OLP2, and OLP3, the possibility of losing the organic material layers may be further reduced. In addition, as the inorganic encapsulation patterns LIP1, LIP2, and LIP3, the organic patterns OLP1, OLP2, and OLP3, and the dummy patterns DMP1, DMP2, and DMP3 finally have a shape in which they are completely covered by the inorganic film IOL, the durability of the display panel DP may be improved.

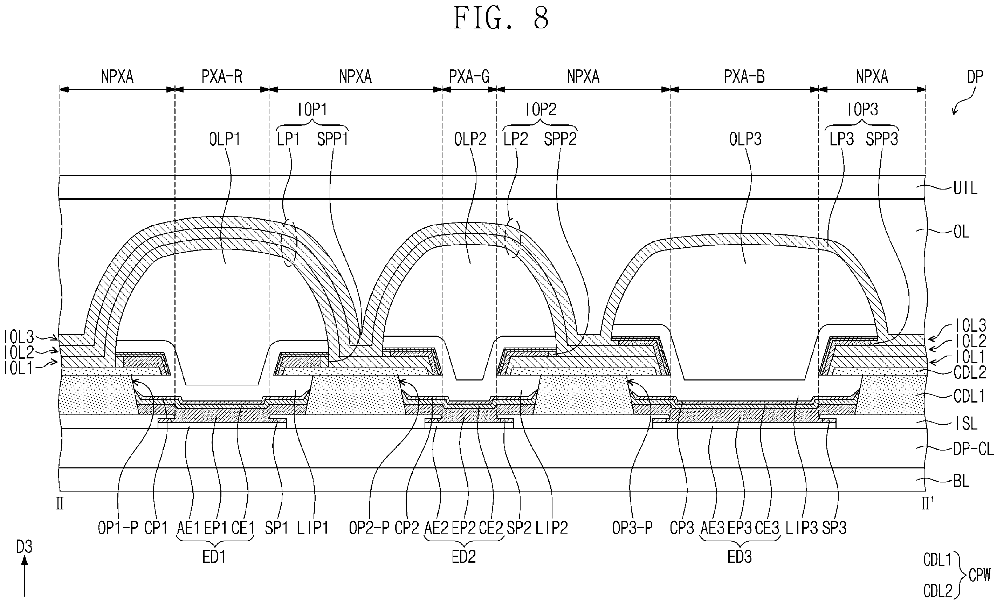

Each of FIGS. 7 and 8 is a cross-sectional view of an embodiment of the display panel according to the inventive concept. Each of FIGS. 7 and 8 illustrates an embodiment of a cross section of the display panel according to the inventive concept different from that of FIG. 6B, which is taken along line II-II' of FIG. 5. The same reference numerals will be used for the same components as those described in FIG. 6B, and the detailed descriptions thereof will be omitted.

Referring to FIG. 7, unlike in FIG. 6B, the dummy patterns DMP1, DMP2, and DMP3 may be provided in a two-layer structure instead of a three-layer structure, and a predetermined space may be provided between the dummy patterns DMP1, DMP2, and DMP3 and the bank layer CPW.

More specifically, the first dummy patterns DMP1 may include (2-1)-th layer dummy patterns D2-1 and (3-1)-th layer dummy patterns D3-1, the second dummy patterns DMP2 may include (2-2)-th layer dummy patterns D2-2 and (3-2)-th layer dummy patterns D3-2, and the third dummy patterns DMP3 may include (2-3)-th layer dummy patterns D2-3 and (3-3)-th layer dummy patterns D3-3. In the display panel DP illustrated in FIG. 7, the first layer dummy patterns D1-1, D1-2, and D1-3 illustrated in FIG. 6B may be omitted.

Separation portions SS1, SS2, and SS3 may be defined between the second layer dummy patterns D2-1, D2-2, and D2-3 and the bank layer CPW. A first separation portion SS1 may be defined between the (2-1)-th layer dummy patterns D2-1 and the bank layer CPW, a second separation portion SS2 may be defined between the (2-2)-th layer dummy patterns D2-2 and the bank layer CPW, and a third separation portion SS3 may be defined between the (2-3)-th layer dummy patterns D2-3 and the bank layer CPW. The separation portions SS1, SS2, and SS3 defined between the second layer dummy patterns D2-1, D2-2, and D2-3 and the bank layer CPW may be formed through the loss of the first layer dummy patterns D1-1, D1-2, and D1-3 including or consisting of an organic material like the light-emitting patterns EP1, EP2, and EP3 when a process for etching an organic material is performed in an intermediate operation of a display panel manufacturing process.

In the display panel in an embodiment of the inventive concept, since the light-emitting patterns EP1, EP2, and EP3 and the dummy patterns DMP1, DMP2, and DMP3 are covered by the thick organic patterns OLP1, OLP2, and OLP3, it is possible to prevent a defect in which the dummy patterns DMP1, DMP2, and DMP3 are lifted off although the separation portions SS1, SS2, and SS3 are formed due to partial loss of the dummy patterns DMP1, DMP2, and DMP3, and therefore, the durability of the display panel DP may be improved.

Referring to FIG. 8, unlike in FIG. 6B, the thicknesses of the inorganic films IOL1, IOL2, and IOL3 respectively disposed to correspond to the first to third light-emitting regions PXA-R, PXA-G, and PXA-B may be different from each other. More specifically, the first inorganic portion IOP1 corresponding to the first light-emitting region PXA-R may have a larger thickness than the second inorganic portion IOP2 corresponding to the second light-emitting region PXA-G and the third inorganic portion IOP3 corresponding to the third light-emitting region PXA-B, and the second inorganic portion IOP2 may have a larger thickness than the third inorganic portion IOP3.

The first layer portion LP1 of the first inorganic portion IOP1, which has a three-layer structure in which the first inorganic film IOL1, the second inorganic film IOL2, and the third inorganic film IOL3 are disposed, may be disposed in the first light-emitting region PXA-R. The second layer portion LP2 of the second inorganic portion IOP2, which has a two-layer structure in which the second inorganic film IOL2 and the third inorganic film IOL3 are disposed, may be disposed in the second light-emitting region PXA-G. The third layer portion LP3 of the third inorganic portion IOP3, which has a one-layer structure in which the third inorganic film IOL3 is disposed, may be disposed in the third light-emitting region PXA-B. In the first light-emitting region PXA-R, the first inorganic film IOL1 may be disposed directly on the first organic pattern OLP1, the second inorganic film IOL2 may be disposed directly on the first inorganic film IOL1, and the third inorganic film IOL3 may be disposed directly on the second inorganic film IOL2. In the second light-emitting region PXA-G, the second inorganic film IOL2 may be disposed directly on the second organic pattern OLP2, and the third inorganic film IOL3 may be disposed directly on the second inorganic film IOL2. In the third light-emitting region PXA-B, the third inorganic film IOL3 may be disposed directly on the third organic pattern OLP3.

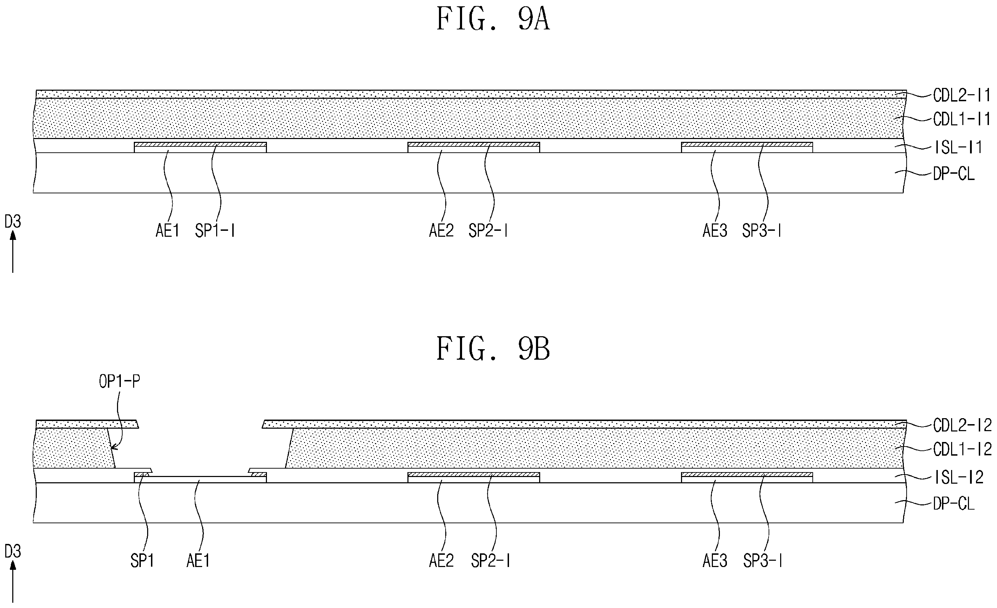

FIGS. 9A to 9Q are cross-sectional views illustrating some operations of a method of manufacturing a display panel according to the inventive concept. In the description of FIGS. 9A to 9Q, the same/similar reference numerals will be used for the same/similar elements as those described with reference to FIGS. 1A to 8, and redundant descriptions will be omitted.

A method of manufacturing a display panel according to this inventive concept includes: providing a preliminary display panel including a base layer, a first anode disposed on the base layer, a preliminary pixel defining film disposed on the base layer and covering the first anode, and a preliminary bank layer disposed on the preliminary pixel defining film and including or consisting of a conductive material, defining a first pixel opening, which corresponds to the first anode and exposes an upper surface of the first anode, in the preliminary bank layer, forming a first light-emitting element in the first pixel opening by sequentially forming a first light-emitting pattern and a first cathode on the first anode, forming a first preliminary inorganic encapsulation layer covering the first light-emitting element and the preliminary bank layer: forming a first organic pattern, which at least partially overlaps the first light-emitting element, on the first preliminary inorganic encapsulation layer, forming a first inorganic encapsulation pattern at least partially overlapping the first light-emitting element by etching the first preliminary inorganic encapsulation layer with the use of the first organic pattern as a mask, and forming a first preliminary inorganic film on the first organic pattern and the preliminary bank layer.

Referring to FIG. 9A, the method of manufacturing the display panel in an embodiment of the inventive concept includes providing a preliminary display panel, where the preliminary display panel includes first to third anodes AE1, AE2, and AE3 disposed on the base layer, a preliminary pixel defining film ISL-I1 disposed on the base layer and covering the first to third anodes AE1, AE2, and AE3, and preliminary bank layers CDL1-I1 and CDL2-I1 disposed on the preliminary pixel defining film ISL-I1 and including or consisting of a conductive material. Although a base layer BL (refer to FIG. 6A) is not illustrated in FIG. 9A, the base layer may be disposed below the circuit element layer DP-CL.

The circuit element layer DP-CL may be formed through a typical circuit element manufacturing process, in which an insulating layer, a semiconductor layer, and a conductive layer is formed by a method such as coating or deposition and then the insulating layer, the semiconductor layer, and the conductive layer is selectively patterned through photolithography and etching processes to form a semiconductor pattern, a conductive pattern, a signal line, or the like.

The first to third anodes AE1, AE2, and AE3 may be formed on a sixth insulating layer 60 (refer to FIG. 6A) of the circuit element layer DP-CL. First to third preliminary sacrificial patterns SP1-I, SP2-I, and SP3-I may be respectively formed on the first to third anodes AE1, AE2, and AE3. The first to third anodes AE1, AE2, and AE3 and the first to third preliminary sacrificial patterns SP1-I, SP2-I, and SP3-I may be formed through a same patterning process.

The preliminary bank layers CDL1-I1 and CDL2-I1 may include a double-layer structure, the first preliminary bank layer CDL1-I1 may include or consist of the same material as that of the first conductive layer CDL1 (refer to FIG. 6B) described above, and the second preliminary bank layer CDL2-I1 may include or consist of the same material as that of the second conductive layer CDL2 (refer to FIG. 6B) described above. The first preliminary bank layer CDL1-I1 may have a first conductivity and a first thickness, and the second preliminary bank layer CDL2-I1 may have a second conductivity lower than the first conductivity and a second thickness smaller than the first thickness.

Referring to FIGS. 9A and 9B, the method of manufacturing the display panel in an embodiment of the inventive concept includes forming the first pixel opening OP1-P, which corresponds to the first anode AE1 and exposes the upper surface of the first anode AE1, in the preliminary bank layers CDL1-I1 and CDL2-I1.

In the defining of the first pixel opening OP1-P, the light-emitting opening OP1-E (refer to FIG. 6A) corresponding to the first pixel opening OP1-P may be formed in the preliminary pixel defining film ISL-I1, and the sacrificial opening OP1-L (refer to FIG. 6A) corresponding to the first pixel opening OP1-P may be formed in the first preliminary sacrificial pattern SP1-I so that the first sacrificial pattern SP1 may be formed.

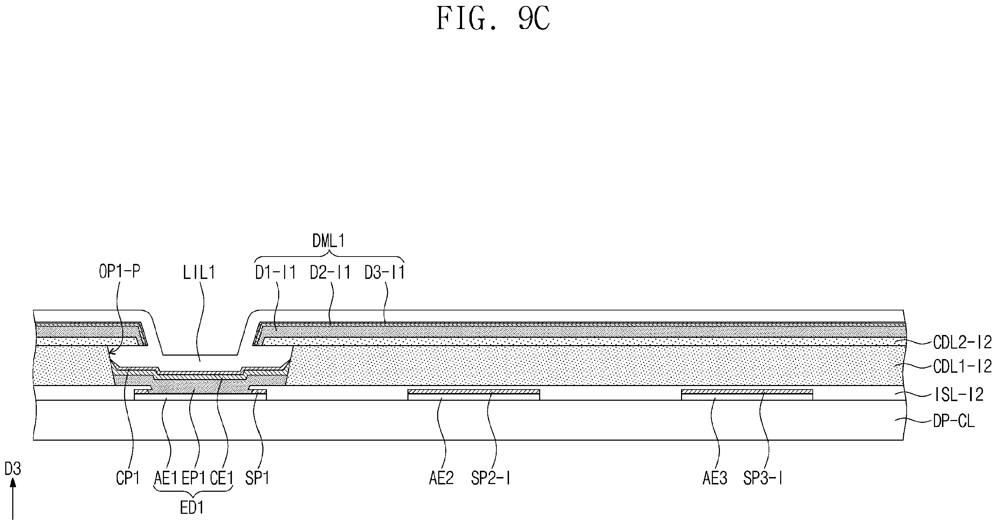

Referring to FIGS. 9B and 9C, the method of manufacturing the display panel in an embodiment of the inventive concept includes forming the first light-emitting element ED1 in the first pixel opening OP1-P by forming the first light-emitting pattern EP1 and the first cathode CE1 sequentially on the first anode AE1. The method of manufacturing the display panel in an embodiment of the inventive concept includes forming a preliminary inorganic encapsulation layer LIL1 which covers the first light-emitting element ED1 and preliminary bank layers CDL1-I2 and CDL2-I2 after the forming of the first light-emitting element ED1.

The method of manufacturing the display panel in an embodiment of the inventive concept may further include forming the first capping pattern CP1 on the first light-emitting element ED1. The first capping pattern CP1 may be formed so as to be disposed in the first pixel opening OP1-P.

In the forming of the first light-emitting element ED1, a first preliminary dummy layer DML1 may be formed on the preliminary bank layers CDL1-I2 and CDL2-I2. The first preliminary dummy layer DML1 may be formed through the same process as the first light-emitting element ED1 and the first capping pattern CP1. The first preliminary dummy layer DML1 may include a (1-1)-th dummy layer D1-I1, a (2-1)-th dummy layer D2-I1, and a (3-1)-th dummy layer D3-I1. The (1-1)-th dummy layer D1-I1 may be formed through the same process as the first light-emitting pattern EP1, the (2-1)-th dummy layer D2-I1 may be formed through the same process as the first cathode CE1, and the (3-1)-th dummy layer D3-I1 may be formed through the same process as the first capping pattern CP1. The first preliminary dummy layer DML1 may be formed to be separated from the first light-emitting element ED1 and the first capping pattern CP1 by the second preliminary bank layer CDL2-I2 which forms a tip portion.

The first preliminary inorganic encapsulation layer LIL1 may cover the first light-emitting element ED1 and the first preliminary dummy layer DML1. A portion of the first preliminary inorganic encapsulation layer LIL1 may be disposed in the first pixel opening OP1-P. The first preliminary inorganic encapsulation layer LIL1 may contact the upper surface of the first capping pattern CP1 and the upper surface of the (3-1)-th dummy layer D3-I1.

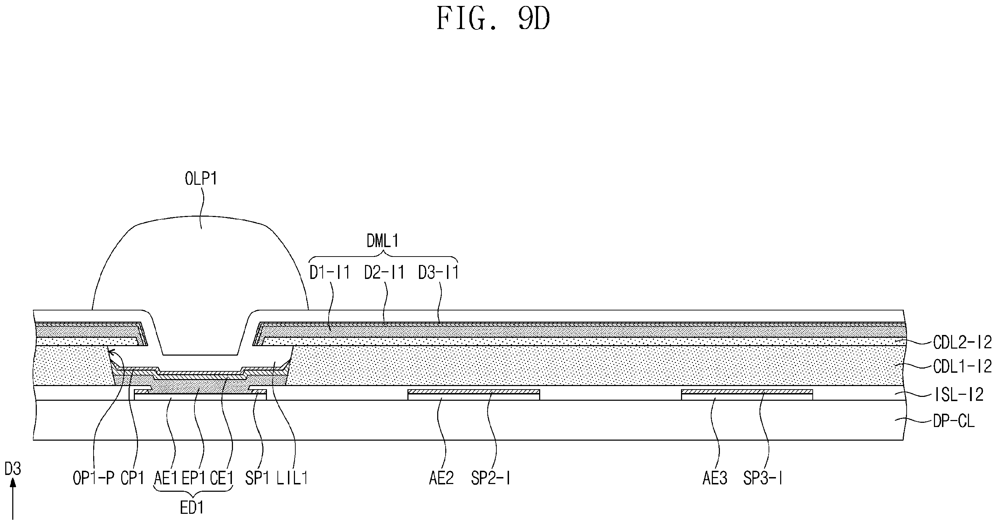

Referring to FIGS. 9C and 9D, the method of manufacturing the display panel in an embodiment of the inventive concept includes forming the first organic pattern OLP1, which at least partially overlaps the first light-emitting element ED1, on the first preliminary inorganic encapsulation layer LIL1.

The first organic pattern OLP1 may be disposed on the first preliminary inorganic encapsulation layer LIL1, and the first organic pattern OLP1 may have a greater thickness than the first preliminary inorganic encapsulation layer LIL1. The first organic pattern OLP1 may be patterned on the first preliminary inorganic encapsulation layer LIL1 so as to have a rounded upper surface. The first organic pattern OLP1 may be disposed to overlap at least the first light-emitting element ED1. The first organic pattern OLP1 may be disposed to correspond to the first pixel openings OP1-P.

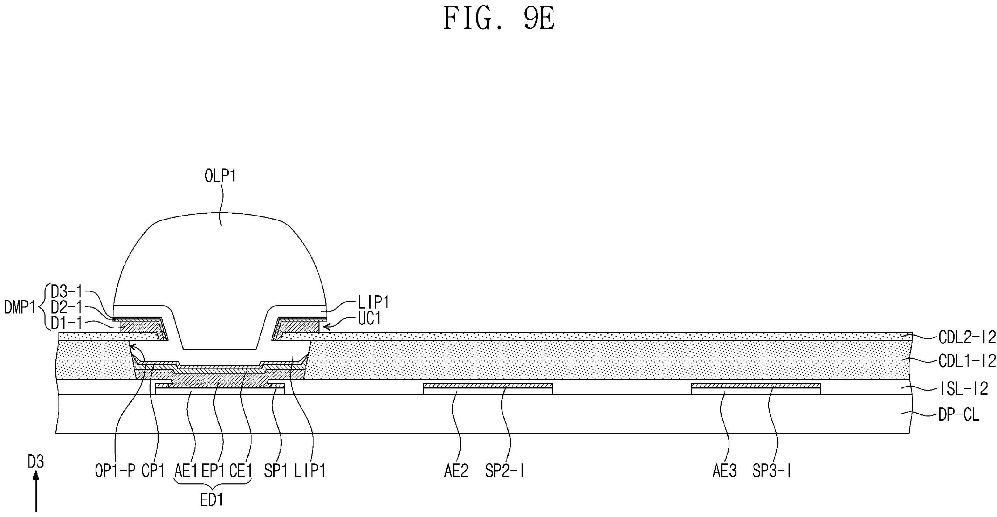

Referring to FIGS. 9D and 9E, the method of manufacturing the display panel in an embodiment of the inventive concept includes forming the first inorganic encapsulation pattern LIP1 at least partially overlapping the first light-emitting element ED1 by etching the first preliminary inorganic encapsulation layer LIL1 with the use of the first organic pattern OLP1 as a mask.

In a state in which the first inorganic encapsulation pattern LIP1 is formed, the first organic pattern OLP1 may be disposed to cover an entirety of the first inorganic encapsulation pattern LIP1 in a plan view. That is, the first organic pattern OLP1 may be disposed only on a portion in which the first inorganic encapsulation pattern LIP1 is disposed based on the third direction DR3.

In the forming of the first inorganic encapsulation pattern LIP1, a portion of the first preliminary dummy layer DML1 may be etched to form the first dummy pattern DMP1. The first dummy pattern DMP1 may be formed to be recessed more inward than the end of the first inorganic encapsulation pattern LIP1. That is, the first dummy pattern DMP1 may be formed to be recessed inward so that a predetermined first separation portion UC1 is defined between the first inorganic encapsulation pattern LIP1 and the preliminary bank layers CDL1-I2 and CDL2-I2.

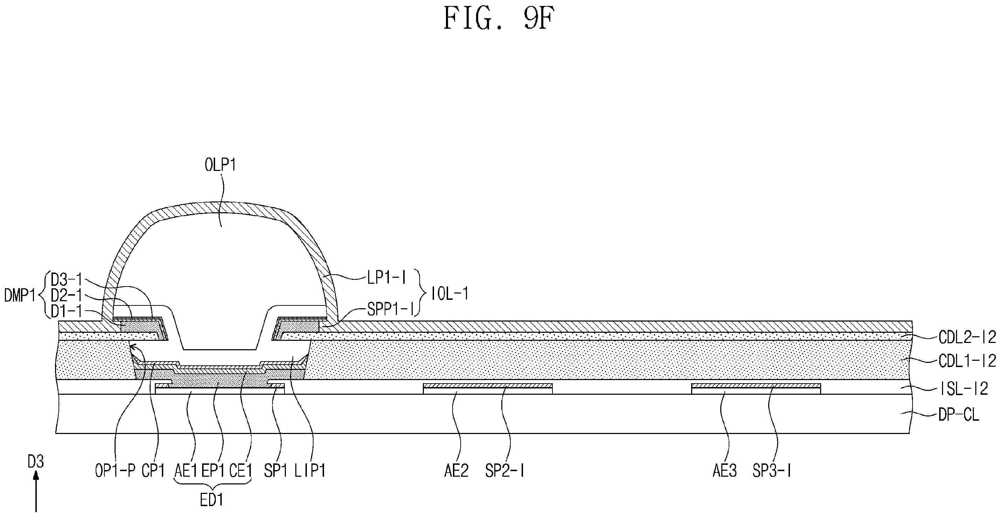

Referring to FIGS. 9E and 9F, the method of manufacturing the display panel in an embodiment of the inventive concept includes forming a first preliminary inorganic film IOL-1 on the first organic pattern OLP1 and the preliminary bank layers CDL1-I2 and CDL2-I2.

A portion of the first preliminary inorganic film IOL-1 may be formed to contact the first dummy pattern DMP1. The portion of the first preliminary inorganic film IOL-1 may be disposed in the aforementioned first separation portion UC1 and contact the first dummy pattern DMP1. The first preliminary inorganic film IOL-1 may include a first preliminary spacer portion SPP1-I and a first preliminary layer portion LP1-I. The first preliminary spacer portion SPP1-I may correspond to a portion of the first preliminary inorganic film IOL-1 disposed between the first inorganic encapsulation pattern LIP1 and the preliminary bank layers CDL1-I2 and CDL2-I2. The first preliminary layer portion LP1-I may be disposed to cover the upper portion of the first organic pattern OLP1 and the upper portion of the preliminary bank layers CDL1-I2 and CDL2-I2.

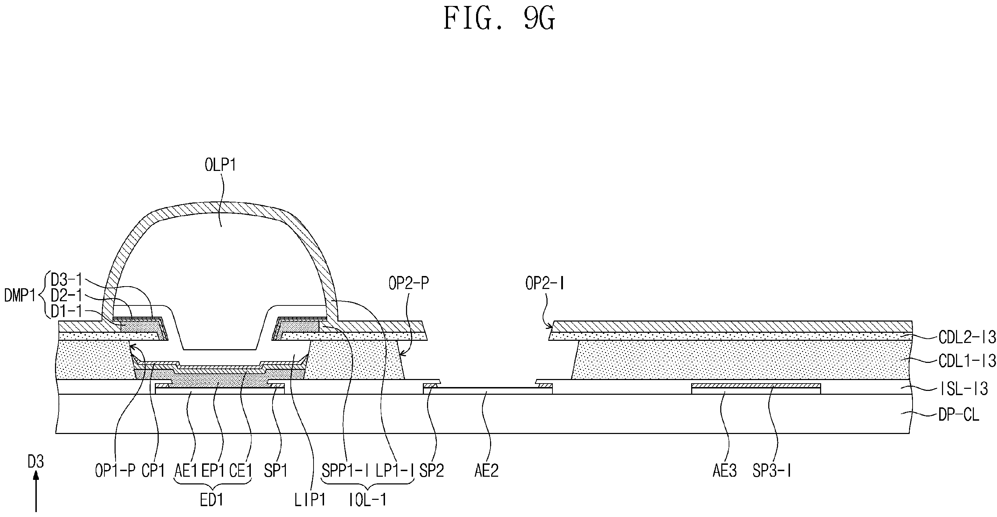

Referring to FIGS. 9F and 9G, the method of manufacturing the display panel in an embodiment of the inventive concept may include forming the second pixel opening OP2-P, which corresponds to the second anode AE2 and exposes the upper surface of the second anode AE2, in the preliminary bank layers CDL1-I2 and CDL2-I2.

In the defining of the second pixel opening OP2-P, a light-emitting opening corresponding to the second pixel opening OP2-P may be formed in a preliminary pixel defining film ISL-I2. A sacrificial opening corresponding to the second pixel opening OP2-P may be formed in the second preliminary sacrificial pattern SP2-I so that the second sacrificial pattern SP2 may be formed. In the defining of the second pixel opening OP2-P, a second inorganic opening OP2-I corresponding to the second pixel opening OP2-P may be formed in the first preliminary inorganic film IOL-1.

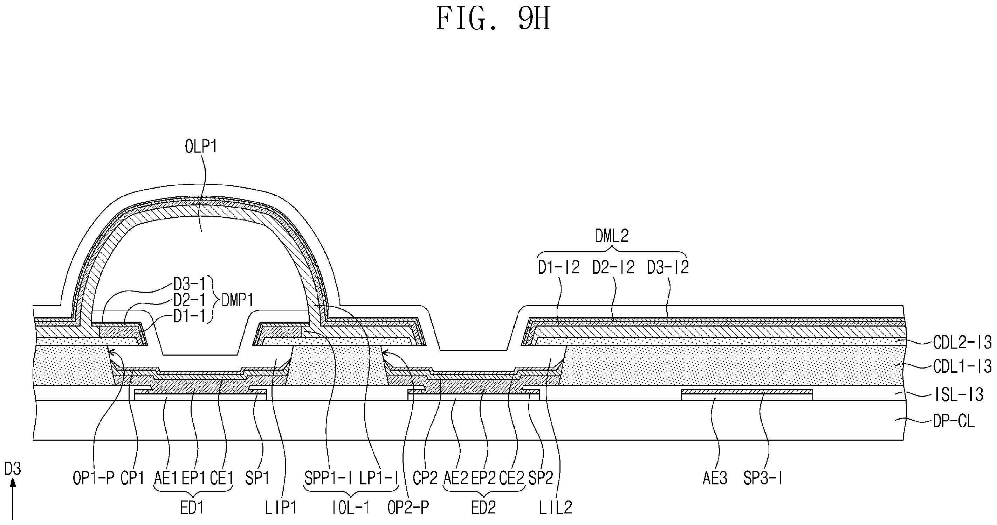

Referring to FIGS. 9G and 9H, the method of manufacturing the display panel in an embodiment of the inventive concept may include forming the second light-emitting element ED2 in the second pixel opening OP2-P by forming the second light-emitting pattern EP2 and the second cathode CE2 sequentially on the second anode AE2. The method of manufacturing the display panel in an embodiment of the inventive concept may include forming a second preliminary inorganic encapsulation layer LIL2 which covers the second light-emitting element ED2 and preliminary bank layers CDL1-I3 and CDL2-I3 after the forming of the second light-emitting element ED2.

The method of manufacturing the display panel in an embodiment of the inventive concept may further include forming the second capping pattern CP2 on the second light-emitting element ED2. The second capping pattern CP2 may be formed to be disposed in the second pixel opening OP2-P.

In the forming of the second light-emitting element ED2, a second preliminary dummy layer DML2 may be formed on the preliminary bank layers CDL1-I3 and CDL2-I3. The second preliminary dummy layer DML2 may be disposed on the first preliminary layer portion LP1-I of the first preliminary inorganic film IOL-1.

The second preliminary dummy layer DML2 may be formed through the same process as the second light-emitting element ED2 and the second capping pattern CP2. The second preliminary dummy layer DML2 may include a (1-2)-th dummy layer D1-I2, a (2-2)-th dummy layer D2-I2, and a (3-2)-th dummy layer D3-I2. The (1-2)-th dummy layer D1-I2 may be formed through the same process as the second light-emitting pattern EP2, the (2-2)-th dummy layer D2-I2 may be formed through the same process as the second cathode CE2, and the (3-2)-th dummy layer D3-I2 may be formed through the same process as the second capping pattern CP2. The second preliminary dummy layer DML2 may be formed to be separated from the second light-emitting element ED2 and the second capping pattern CP2 by the second preliminary bank layer CDL2-I3 which forms a tip portion.

The second preliminary inorganic encapsulation layer LIL2 may cover the second light-emitting element ED2 and the second preliminary dummy layer DML2. A portion of the second preliminary inorganic encapsulation layer LIL2 may be disposed in the second pixel opening OP2-P. The second preliminary inorganic encapsulation layer LIL2 may contact the upper surface of the second capping pattern CP2 and the upper surface of the (3-2)-th dummy layer D3-I2.

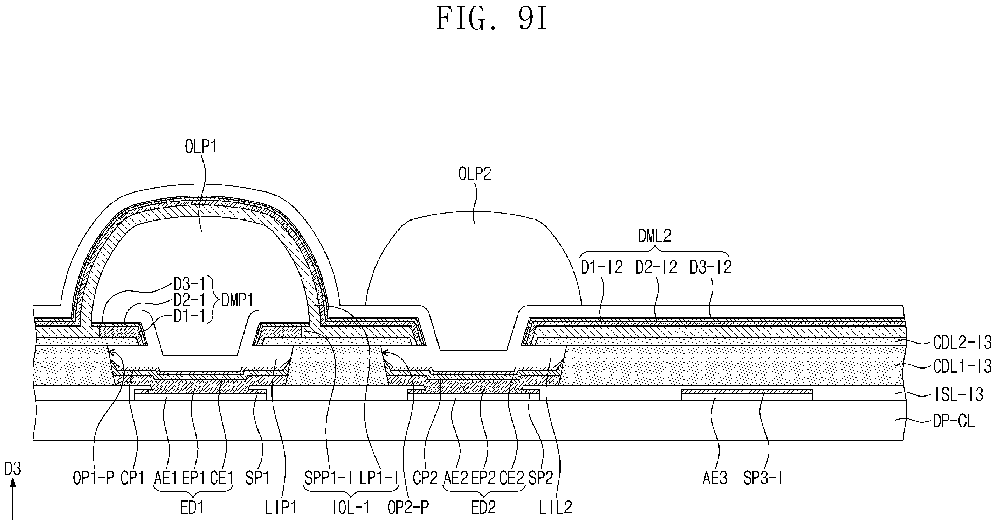

Referring to FIGS. 9H and 9I, the method of manufacturing the display panel in an embodiment of the inventive concept includes forming the second organic pattern OLP2, which at least partially overlaps the second light-emitting element ED2, on the second preliminary inorganic encapsulation layer LIL2.

The second organic pattern OLP2 may be disposed on the second preliminary inorganic encapsulation layer LIL2, and the second organic pattern OLP2 may have a greater thickness than the second preliminary inorganic encapsulation layer LIL2. The second organic pattern OLP2 may be patterned on the second preliminary inorganic encapsulation layer LIL2 so as to have a rounded upper surface. The second organic pattern OLP2 may be disposed to overlap at least the second light-emitting element ED2. The second organic pattern OLP2 may be disposed to correspond to the second pixel opening OP2-P.

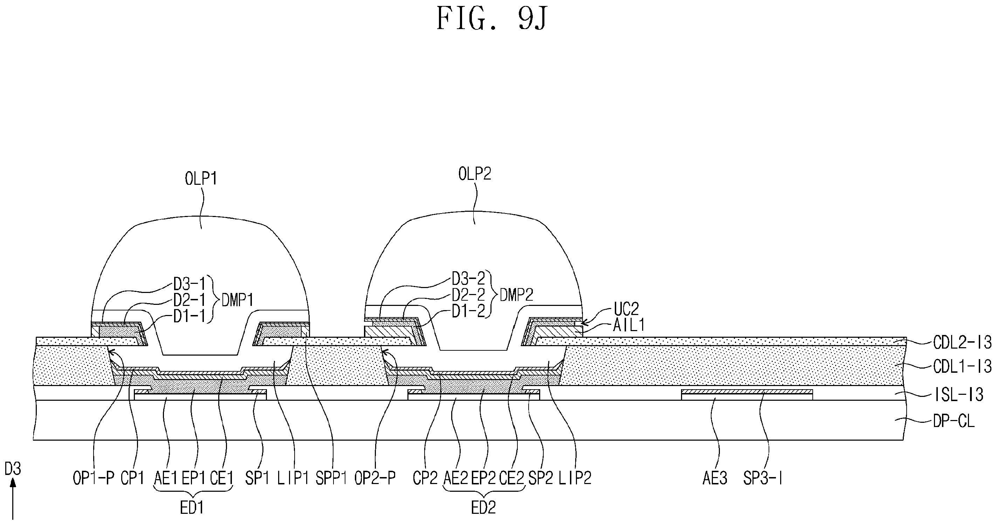

Referring to FIGS. 9I and 9J, the method of manufacturing the display panel in an embodiment of the inventive concept may include forming the second inorganic encapsulation pattern LIP2 at least partially overlapping the second light-emitting element ED2 by etching the second preliminary inorganic encapsulation layer LIL2 with the use of the second organic pattern OLP2 as a mask.

In a state in which the second inorganic encapsulation pattern LIP2 is formed, the second organic pattern OLP2 may be disposed to cover an entirety of the second inorganic encapsulation pattern LIP2 in a plan view. That is, the second organic pattern OLP2 may be disposed only on a portion in which the second inorganic encapsulation pattern LIP2 is disposed based on the third direction DR3.

In the forming of the second inorganic encapsulation pattern LIP2, a portion of the first preliminary inorganic film IOL-1 may be etched. In the forming of the second inorganic encapsulation pattern LIP2, the first preliminary spacer portion SPP1-I of the first preliminary inorganic film IOL-1 and a remaining portion other than the preliminary layer portion LP1-I disposed below the second organic pattern OLP2 may be etched. As the portion of the first preliminary inorganic film IOL-1 is etched, the first spacer portion SPP1 disposed between the first inorganic encapsulation pattern LIP1 and the preliminary bank layers CDL1-I3 and CDL2-I3 may be formed. In addition, the first preliminary layer portion LP1-I disposed below the second organic pattern OLP2 may remain to form the first additional inorganic pattern AIL1. The first additional inorganic pattern AIL1 may be formed between the second inorganic encapsulation pattern LIP2 and the preliminary bank layers CDL1-I3 and CDL2-I3.

In the forming of the second inorganic encapsulation pattern LIP2, a portion of the second preliminary dummy layer DML2 may be etched to form the second dummy pattern DMP2. The second dummy pattern DMP2 may be formed to be recessed more inward than the end of the second inorganic encapsulation pattern LIP2. That is, the second dummy pattern DMP2 may be formed to be recessed inward so that a predetermined second separation portion UC2 is defined between the second inorganic encapsulation pattern LIP2 and the preliminary bank layers CDL1-I3 and CDL2-I3.

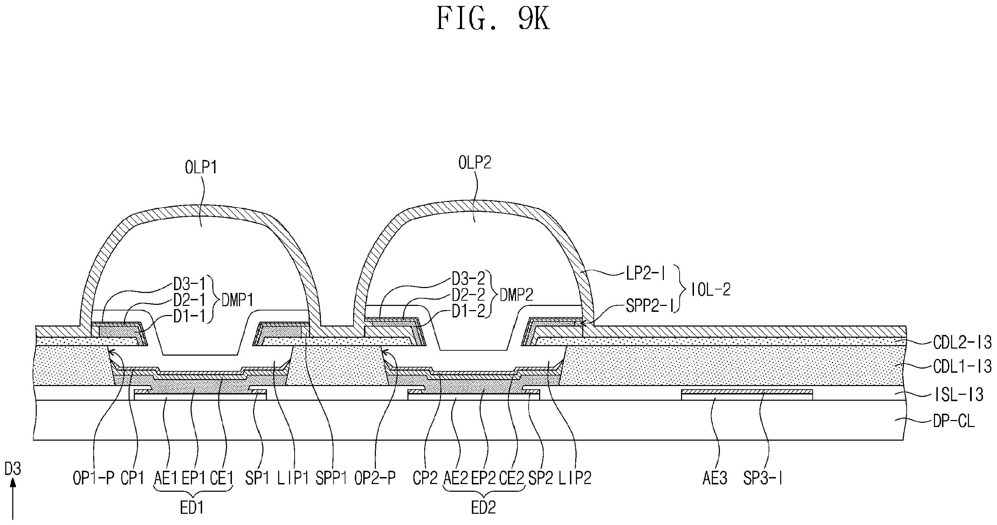

Referring to FIGS. 9J and 9K, the method of manufacturing the display panel in an embodiment of the inventive concept includes forming a second preliminary inorganic film IOL-2 on the second organic pattern OLP2 and the preliminary bank layers CDL1-I3 and CDL2-I3.

A portion of the second preliminary inorganic film IOL-2 may be formed to contact the second dummy pattern DMP2. The portion of the second preliminary inorganic film IOL-2 may be disposed in the aforementioned second separation portion UC2 and contact the second dummy pattern DMP2. The second preliminary inorganic film IOL-2 may include a second preliminary spacer portion SPP2-I and a second preliminary layer portion LP2-I. The second preliminary spacer portion SPP2-I may correspond to a portion of the second preliminary inorganic film IOL-2 disposed between the second inorganic encapsulation pattern LIP2 and the preliminary bank layers CDL1-I3 and CDL2-I3. The second preliminary layer portion LP2-I may be disposed to cover the upper portion of the second organic pattern OLP2 and the upper portions of the preliminary bank layers CDL1-I3 and CDL2-I3.

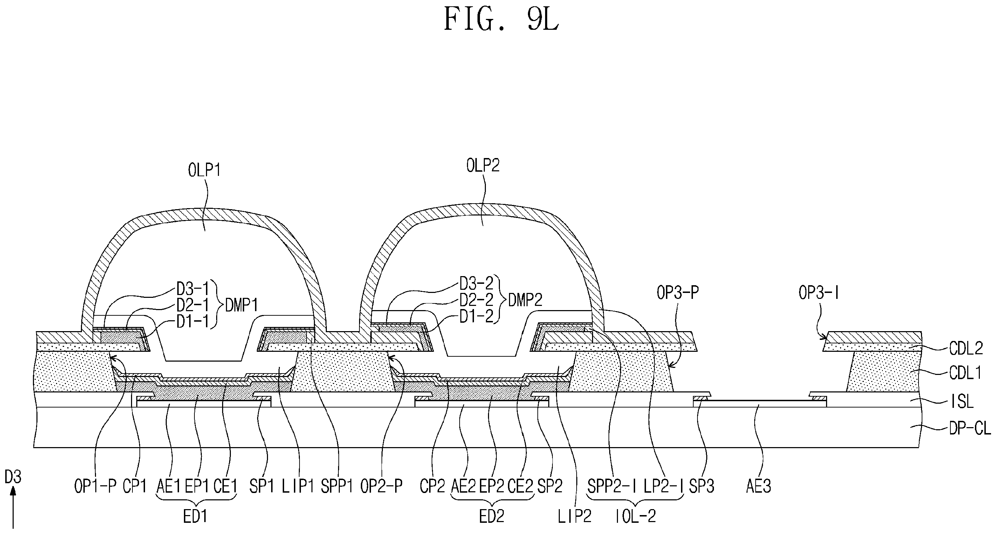

Referring to FIGS. 9K and 9L, the method of manufacturing the display panel in an embodiment of the inventive concept may include forming the third pixel opening OP3-P, which corresponds to the third anode AE3 and exposes the upper surface of the third anode AE3, in the preliminary bank layers CDL1-I3 and CDL2-I3. As the third pixel opening OP3-P is formed, the bank layers CDL1 and CDL2 may be formed.

In the defining of the third pixel opening OP3-P, a light-emitting opening corresponding to the third pixel opening OP3-P may be formed in the preliminary pixel defining film ISL-I3 so that the pixel defining film ISL may be formed. A sacrificial opening corresponding to the third pixel opening OP3-P may be formed in the third preliminary sacrificial pattern SP3-I so that the third sacrificial pattern SP3 may be formed. In the defining of the third pixel opening OP3-P, a third inorganic opening OP3-I corresponding to the third pixel opening OP3-P may be formed in the second preliminary inorganic film IOL-2.

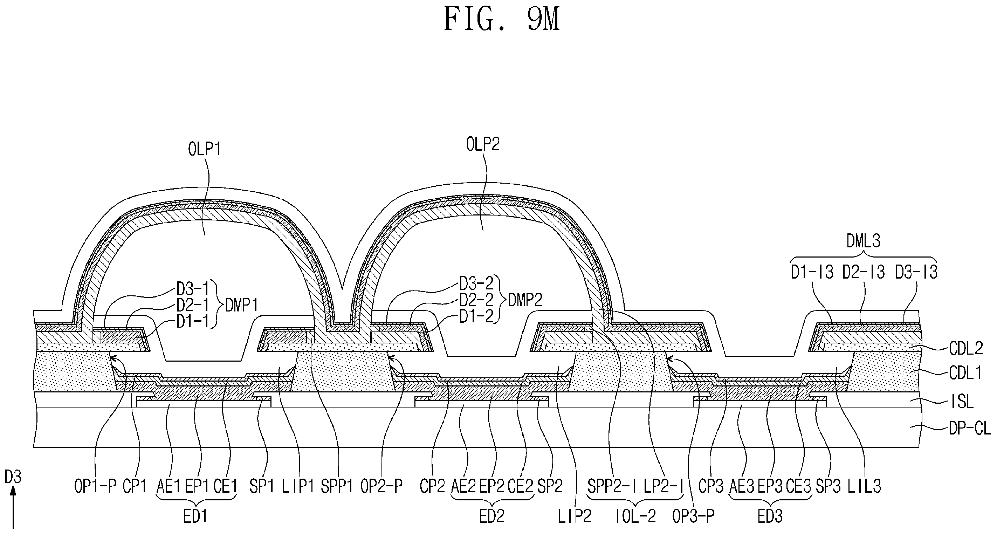

Referring to FIGS. 9L and 9M, the method of manufacturing the display panel in an embodiment of the inventive concept may include forming the third light-emitting element ED3 by forming the third light-emitting pattern EP3 and the third cathode CE3 sequentially on the third anode AE3 in the third pixel opening OP3-P. The method of manufacturing the display panel in an embodiment of the inventive concept may include forming a third preliminary inorganic encapsulation layer LIL3 covering the third light-emitting element ED3 and the bank layers CDL1 and CDL2 after the forming of the third light-emitting element ED3.

The method of manufacturing the display panel in an embodiment of the inventive concept may further include forming the third capping pattern CP3 on the third light-emitting element ED3. The third capping pattern CP3 may be formed to be disposed in the third pixel opening OP3-P.

In the forming of the third light-emitting element ED3, a third preliminary dummy layer DML3 may be formed on the bank layers CDL1 and CDL2. The third preliminary dummy layer DML3 may be disposed on the second preliminary layer portion LP2-I of the second preliminary inorganic film IOL-2.

The third preliminary dummy layer DML3 may be formed through the same process as the third light-emitting element ED3 and the third capping pattern CP3. The third preliminary dummy layer DML3 may include a (1-3)-th dummy layer D1-I3, a (2-3)-th dummy layer D2-13, and a (3-3)-th dummy layer D3-I3. The (1-3)-th dummy layer D1-I3 may be formed through the same process as the third light-emitting pattern EP3, the (2-3)-th dummy layer D2-I3 may be formed through the same process as the third cathode CE3, and the (3-3)-th dummy layer D3-I3 may be formed through the same process as the third capping pattern CP3. The third preliminary dummy layer DML3 may be formed to be separated from the third light-emitting element ED3 and the third capping pattern CP3 by the second conductive layer CDL2 which forms a tip portion.

The third preliminary inorganic encapsulation layer LIL3 may cover the third light-emitting element ED3 and the third preliminary dummy layer DML3. A portion of the third preliminary inorganic encapsulation layer LIL3 may be disposed in the third pixel opening OP3-P. The third preliminary inorganic encapsulation layer LIL3 may contact the upper surface of the third capping pattern CP3 and the upper surface of the (3-3)-th dummy layer D3-I3.

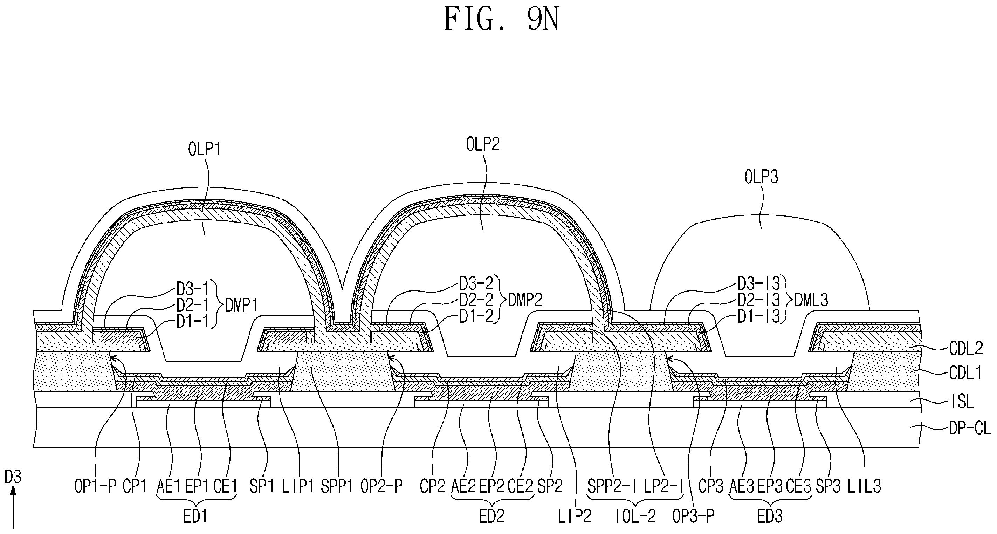

Referring to FIGS. 9M and 9N, the method of manufacturing the display panel in an embodiment of the inventive concept includes forming the third organic pattern OLP3 at least partially overlapping the third light-emitting element ED3 on the third preliminary inorganic encapsulation layer LIL3.

The third organic pattern OLP3 may be disposed on the third preliminary inorganic encapsulation layer LIL3, and the third organic pattern OLP3 may have a greater thickness than the third preliminary inorganic encapsulation layer LIL3. The third organic pattern OLP3 may be patterned on the third preliminary inorganic encapsulation layer LIL3 so as to have a rounded upper surface. The third organic pattern OLP3 may be disposed to overlap at least the third light-emitting element ED3. The third organic pattern OLP3 may be disposed to correspond to the third pixel opening OP3-P.

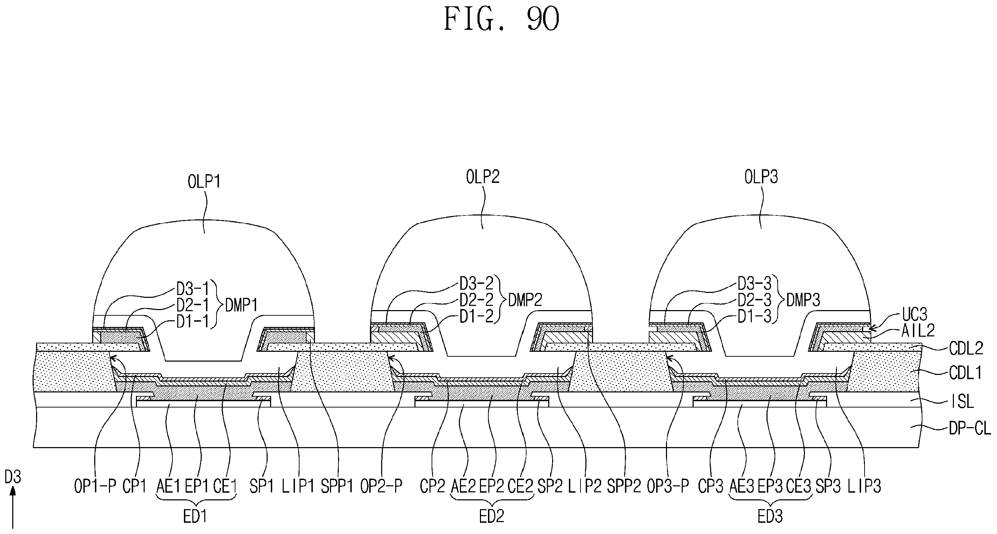

Referring to FIGS. 9N and 9O, the method of manufacturing the display panel in an embodiment of the inventive concept may include forming the third inorganic encapsulation pattern LIP3 at least partially overlapping the third light-emitting element ED3 by etching the third preliminary inorganic encapsulation layer LIL3 with the use of the third organic pattern OLP3 as a mask.

In a state in which the third inorganic encapsulation pattern LIP3 is formed, the third organic pattern OLP3 may be disposed to cover an entirety of the third inorganic encapsulation pattern LIP3 in a plan view. That is, the third organic pattern OLP3 may be disposed only on a portion in which the third inorganic encapsulation pattern LIP3 is disposed based on the third direction DR3.

In the forming of the third inorganic encapsulation pattern LIP3, a portion of the second preliminary inorganic film IOL-2 may be etched. In the forming of the third inorganic encapsulation pattern LIP3, the second preliminary spacer portion SPP2-I of the second preliminary inorganic film IOL-2 and a remaining portion other than the second preliminary layer portion LP2-I disposed below the third organic pattern OLP3 may be etched. As a portion of the second preliminary inorganic film IOL-2 is etched, the second spacer portion SPP2 disposed between the second inorganic encapsulation pattern LIP2 and the bank layers CDL1 and CDL2 may be formed. In addition, the second preliminary layer portion LP2-I disposed below the third organic pattern OLP3 may remain to form the second additional inorganic pattern AIL2. The second additional inorganic pattern AIL2 may be formed between the third inorganic encapsulation pattern LIP3 and the bank layers CDL1 and CDL2.

In the forming of the third inorganic encapsulation pattern LIP3, a portion of the third preliminary dummy layer DML3 may be etched to form the third dummy pattern DMP3. The third dummy pattern DMP3 may be formed to be recessed more inward than the end of the third inorganic encapsulation pattern LIP3. That is, the third dummy pattern DMP3 may be formed to be recessed inward so that a predetermined third separation portion UC3 is defined between the third inorganic encapsulation pattern LIP3 and the bank layers CDL1 and CDL2.

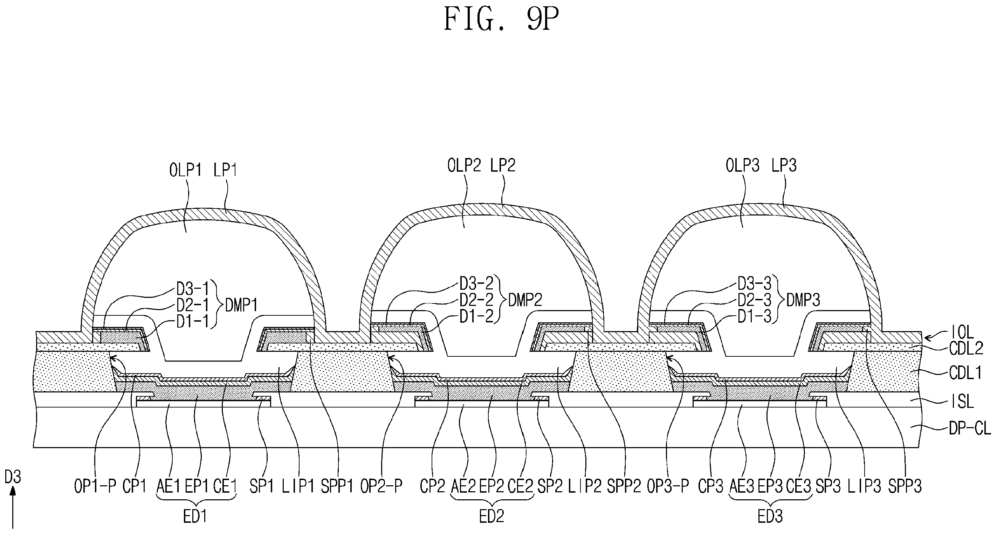

Referring to FIGS. 9O and 9P, the method of manufacturing the display panel in an embodiment of the inventive concept includes forming the inorganic film IOL on the third organic pattern OLP3 and the bank layers CDL1 and CDL2.

A portion of the inorganic film IOL is formed to contact the third dummy pattern DMP3. The portion of the inorganic film IOL may be disposed in the aforementioned third separation portion UC3 and contact the third dummy pattern DMP3. The inorganic film IOL may include a third spacer portion SPP3 and a third layer portion LP3. Since the third spacer portion SPP3 and the third layer portion LP3 are formed through a same process, they may have an integral shape.

The inorganic film IOL includes a first layer portion LP1 which covers the first organic pattern OLP1 and a second layer portion LP2 which covers the second organic pattern OLP2. Since the first layer portion LP1 and the first spacer portion SPP1 are formed in different process operations as described above, the first layer portion LP1 and the first spacer portion SPP1 may have a shape in which they are separated from each other and have an interface therebetween. As described above, since the second layer portion LP2 and the second spacer portion SPP2 are formed in different process operations, the second layer portion LP2 and the second spacer portion SPP2 may have a shape in which they are separated from each other and have an interface therebetween.

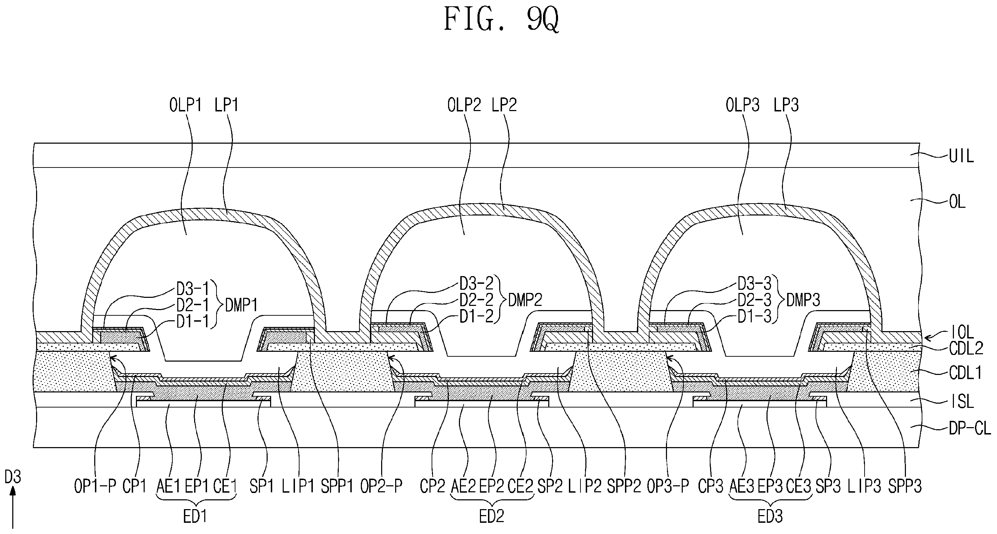

Referring to FIGS. 9P and 9Q, the method of manufacturing the display panel in an embodiment of the inventive concept may include sequentially forming the encapsulation organic film OL and the upper encapsulation inorganic film UIL on the inorganic film IOL. The encapsulation organic film OL may cover the inorganic film IOL, be formed to be thick, and provide a flat upper surface. The upper encapsulation inorganic film UIL may prevent moisture/oxygen from entering and improve the durability of the display panel.

According to the display panel in an embodiment of the inventive concept, it is possible to prevent a defect such as lift-off, which may occur due to loss of organic patterns in an intermediate process operation and therefore, the durability and reliability of the display panel may be improved.

Although the above has been described with reference to preferred embodiments of the inventive concept, those skilled in the art or those of ordinary skill in the art will understand that various modifications and changes may be made to the inventive concept within the scope that does not depart from the technical field of the inventive concept described in the claims to be described later. Accordingly, the technical scope of the inventive concept should not be limited to the content described in the detailed description of the specification, but should be determined by the claims described hereinafter.

## Claims

1. A display panel (DP) comprising:
a base layer (BL);
a pixel defining film (ISL) disposed on the base layer (BL) and comprising an inorganic material;
a bank layer (CPW) which is disposed on the pixel defining film (ISL) and in which a plurality of pixel openings (OP1-P, OP2-P, OP3-P) is defined;
a plurality of light-emitting elements (ED1, ED2, ED3) disposed in each of the plurality of pixel openings (OP1-P, OP2-P, OP3-P) and comprising:
an anode (AE1, AE2, AE3);
a light-emitting pattern (EP1, EP2, EP3); and
a cathode (CE1, CE2, CE3) which contacts the bank layer (CPW);
a dummy pattern (DMP1, DMP2, DMP3) disposed on the bank layer (CPW);
an inorganic encapsulation pattern (LIP1, LIP2, LIP3) disposed on the cathode (CE1, CE2, CE3) and comprising a portion disposed on the dummy pattern (DMP1, DMP2, DMP3);
an organic pattern (OLP1, OLP2, OLP3) disposed on the inorganic encapsulation pattern (LIP1, LIP2, LIP3); and
an inorganic film (IOL) disposed on the organic pattern (OLP1, OLP2, OLP3),
**characterized in that** a portion of the inorganic film (IOL) is disposed between the dummy pattern (DMP1, DMP2, DMP3) and the bank layer (CPW).

2. The display panel (DP) of claim 1, wherein:
the plurality of pixel openings (OP1-P, OP2-P, OP3-P) comprises a first pixel opening (OP1-P) and a second pixel opening (OP2-P) spaced apart from each other; and
a light-emitting element (ED) of the plurality of light-emitting elements (ED1, ED2, ED3) comprises:
a first light-emitting element (ED1) disposed in the first pixel opening (OP1-P) and comprising a first anode (AE1), a first light-emitting pattern (EP1), and a first cathode (CE1); and
a second light-emitting element (ED2) disposed in the second pixel opening (OP2-P) and comprising a second anode (AE2), a second light-emitting pattern (EP2), and a second cathode (CE2).

3. The display panel (DP) of claim 2, wherein the dummy pattern (DMP1, DMP2, DMP3) comprises:
a first dummy pattern (DMP1) disposed adjacent to the first pixel opening (OP1-P); and
a second dummy pattern (DMP2) disposed adjacent to the second pixel opening (OP2-P),
wherein:
the first dummy pattern (DMP1) is separated from the first light-emitting pattern (EP1) and the first cathode (CE1); and
the second dummy pattern (DMP2) is separated from the second light-emitting pattern (EP2) and the second cathode (CE2).

4. The display panel (DP) of claim 3, further comprising an additional inorganic pattern (AIL1) disposed between the second dummy pattern (DMP2) and the bank layer (CPW).

5. The display panel (DP) of any one of claims 2 to 4, wherein:
the inorganic encapsulation pattern (LIP1, LIP2, LIP3) comprises a first inorganic encapsulation pattern (LIP1) disposed on the first light-emitting element (ED1) and a second inorganic encapsulation pattern (LIP2) disposed on the second light-emitting element (ED2) and spaced apart from the first inorganic encapsulation pattern (LIP1); and
the organic pattern (OLP1, OLP2, OLP3) comprises a first organic pattern (OLP1) disposed on the first inorganic encapsulation pattern (LIP1) and a second organic pattern (OLP2) disposed on the second inorganic encapsulation pattern (LIP2) and spaced apart from the first organic pattern (OLP1).

6. The display panel (DP) of claim 5, wherein the inorganic film (IOL) comprises:
a first inorganic portion (IOP1) disposed on the first organic pattern (OLP1); and
a second inorganic portion (IOP2) disposed on the second organic pattern (OLP2),
wherein the first inorganic portion (IOP1) and the second inorganic portion (IOP2) have different thicknesses from each other.

7. The display panel (DP) of claim 5, wherein the inorganic film (IOL) comprises:
a first inorganic portion (IOP1) disposed on the first organic pattern (OLP1); and
a second inorganic portion (IOP2) disposed on the second organic pattern (OLP2),
wherein the first inorganic portion (IOP1) and the second inorganic portion (IOP2) extend onto the bank layer (CPW) so as to be connected to each other.

8. The display panel (DP) of any one of claims 1 to 7, wherein the organic pattern (OLP1, OLP2, OLP3) covers an entirety of the inorganic encapsulation pattern (LIP1, LIP2, LIP3) in a plan view.

9. The display panel (DP) of any one of claims 1 to 8, wherein the inorganic film (IOL) comprises:
a spacer portion (SPP1, SPP2, SPP3) disposed between the dummy pattern (DMP1, DMP2, DMP3) and the bank layer (CPW); and
a layer portion (LP1, LP2, LP3) having a shape separated from the spacer portion (SPP1, SPP2, SPP3) and covering upper portions of the organic pattern (OLP1, OLP2, OLP3) and the bank layer (CPW).

10. The display panel (DP) of any one of claims 1 to 9, further comprising a capping pattern (CP1, CP2, CP3) disposed on the cathode (CE1, CE2, CE3) of the plurality of light-emitting elements (ED1, ED2, ED3).

11. The display panel (DP) of any one of claims 1 to 9, wherein:
the inorganic encapsulation pattern (LIP1, LIP2, LIP3) is disposed directly on the cathode (CE1, CE2, CE3) and the dummy pattern (DMP1, DMP2, DMP3);
the organic pattern (OLP1, OLP2, OLP3) is disposed directly on the inorganic encapsulation pattern (LIP1, LIP2, LIP3); and
the inorganic film (IOL) is disposed directly on the organic pattern (OLP1, OLP2, OLP3).

12. The display panel (DP) of any one of claims 1 to 11, further comprising:
an encapsulation organic film (OL) which is disposed on the inorganic film (IOL) and provides a flat upper surface; and
an upper encapsulation inorganic film (UIL) disposed on the encapsulation organic film (OL).

13. The display panel (DP) of any one of claims 1 to 12, wherein:
the bank layer (CPW) comprises a first conductive layer (CDL1) disposed on the pixel defining film (ISL) and a second conductive layer (CDL2) disposed on the first conductive layer (CDL1) and having an undercut shape protruding from one side of the first conductive layer (CDL1); and
the dummy pattern (DMP1, DMP2, DMP3) is disposed on the second conductive layer (CDL2).

14. A method for manufacturing a display panel (DP), the method comprising:
providing a preliminary display panel comprising a base layer (BL), a first anode (AE1) disposed on the base layer (BL), a preliminary pixel defining film (ISL-I1) disposed on the base layer (BL) and covering the first anode (AE1), and a preliminary bank layer (CDL1-I1) disposed on the preliminary pixel defining film (ISL-I1) and comprising a conductive material;
defining a first pixel opening (OP1-P), which corresponds to the first anode (AE1) and exposes an upper surface of the first anode (AE1), in the preliminary bank layer (CDL1-I1);
forming a first light-emitting element (ED1) in the first pixel opening (OP1-P) by sequentially forming a first light-emitting pattern (EP1) and a first cathode (CE1) on the first anode (AE1);
forming a first preliminary inorganic encapsulation layer (LIL1) covering the first light-emitting element (ED1) and the preliminary bank layer (CDL1-I1);
forming a first organic pattern (OLP1) which at least partially overlaps the first light-emitting element (ED1), on the first preliminary inorganic encapsulation layer (LIL1);
forming a first inorganic encapsulation pattern (LIP1) at least partially overlapping the first light-emitting element (ED1) by etching the first preliminary inorganic encapsulation layer (LIL1) with the use of the first organic pattern (OLP1) as a mask; and
forming a first preliminary inorganic film (IOL-1) on the first organic pattern (OLP1) and the preliminary bank layer (CDL1-I1),
wherein a portion of the first preliminary inorganic film (IOL-1) is disposed between the first inorganic encapsulation pattern (LIP1) and the preliminary bank layer (CDL1-I1).

15. The method of claim 14, wherein:
the preliminary display panel further comprises a second anode (AE2) disposed on the base layer (BL);
the pixel defining film (ISL) covers the second anode (AE2); and
after the forming the first preliminary inorganic film (IOL-1), the method further comprises:
defining a second pixel opening (OP2-P), which corresponds to the second anode (AE2) and exposes an upper surface of the second anode (AE2), in the preliminary bank layer (CDL1-I1);
forming a second light-emitting element (ED2) in the second pixel opening (OP2-P) by sequentially forming a second light-emitting pattern (EP2) and a second cathode (CE2) on the second anode (AE2);
forming a second preliminary inorganic encapsulation layer (LIL2) covering the second light-emitting element (ED2) and the preliminary bank layer (CDL1-I1);
forming a second organic pattern (OLP2), which at least partially overlaps the second light-emitting element (ED2), on the second preliminary inorganic encapsulation layer (LIL2);
forming a second inorganic encapsulation pattern (LIP2) at least partially overlapping the second light-emitting element (ED2) by etching the second preliminary inorganic encapsulation layer (LIL2) with the use of the second organic pattern (OLP2) as a mask; and
forming a second preliminary inorganic film (IOL-2) on the second organic pattern (OLP2) and the preliminary bank layer (CDL1-I1).

## Patentansprüche

1. Anzeigefeld (DP), umfassend:
eine Basisschicht (BL);
eine auf der Basisschicht (BL) angeordnete Pixeldefinitionsfolie (ISL), die ein anorganisches Material umfasst;
eine Bankschicht (CPW), die auf der Pixeldefinitionsfolie (ISL) angeordnet ist und in der eine Vielzahl von Pixelöffnungen (OP1-P, OP2-P, OP3-P) definiert ist;
eine Vielzahl von lichtemittierenden Elementen (ED1, ED2, ED3), die in jeder der Vielzahl von Pixelöffnungen (OP1-P, OP2-P, OP3-P) angeordnet sind und Folgendes umfassen:
eine Anode (AE1, AE2, AE3);
ein lichtemittierendes Muster (EP1, EP2, EP3); und
eine Kathode (CE1, CE2, CE3), die mit der Bankschicht (CPW) in Kontakt steht;
ein Dummy-Muster (DMP1, DMP2, DMP3), das auf der Bankschicht (CPW) angeordnet ist;
ein anorganisches Verkapselungsmuster (LIP1, LIP2, LIP3), das auf der Kathode (CE1, CE2, CE3) angeordnet ist und einen Abschnitt umfasst, der auf dem Dummy-Muster (DMP1, DMP2, DMP3) angeordnet ist;
ein organisches Muster (OLP1, OLP2, OLP3), das auf dem anorganischen Verkapselungsmuster (LIP1, LIP2, LIP3) angeordnet ist; und
einen anorganischen Film (IOL), der auf dem organischen Muster (OLP1, OLP2, OLP3) angeordnet ist,
**dadurch gekennzeichnet, dass** ein Abschnitt des anorganischen Films (IOL) zwischen dem Dummy-Muster (DMP1, DMP2, DMP3) und der Bankschicht (CPW) angeordnet ist.

2. Anzeigefeld (DP) nach Anspruch 1, wobei:
die Vielzahl der Pixelöffnungen (OP1-P, OP2-P, OP3-P) eine erste Pixelöffnung (OP1-P) und eine zweite Pixelöffnung (OP2-P) umfasst, die voneinander beabstandet sind; und
ein lichtemittierendes Element (ED) der Vielzahl von lichtemittierenden Elemente (ED1, ED2, ED3) Folgendes umfasst:
ein erstes lichtemittierendes Element (ED1), das in der ersten Pixelöffnung (OP1-P) angeordnet ist und eine erste Anode (AE1), ein erstes lichtemittierendes Muster (EP1) und eine erste Kathode (CE1) umfasst; und
ein zweites lichtemittierendes Element (ED2), das in der zweiten Pixelöffnung (OP2-P) angeordnet ist und eine zweite Anode (AE2), ein zweites lichtemittierendes Muster (EP2) und eine zweite Kathode (CE2) umfasst.

3. Anzeigefeld (DP) nach Anspruch 2, wobei das Dummy-Muster (DMP1, DMP2, DMP3) Folgendes umfasst:
ein erstes Dummy-Muster (DMP1), das angrenzend zu der ersten Pixelöffnung (OP1-P) angeordnet ist; und
ein zweites Dummy-Muster (DMP2), das angrenzend zu der zweiten Pixelöffnung (OP2-P) angeordnet ist,
wobei:
das erste Dummy-Muster (DMP1) vom ersten lichtemittierenden Muster (EP1) und der ersten Kathode (CE1) getrennt ist; und
das zweite Dummy-Muster (DMP2) vom zweiten lichtemittierenden Muster (EP2) und der zweiten Kathode (CE2) getrennt ist.

4. Anzeigefeld (DP) nach Anspruch 3, weiter umfassend ein zusätzliches anorganisches Muster (AIL1), das zwischen dem zweiten Dummy-Muster (DMP2) und der Bankschicht (CPW) angeordnet ist.

5. Anzeigefeld (DP) nach einem der Ansprüche 2 bis 4, wobei:
das anorganische Verkapselungsmuster (LIP1, LIP2, LIP3) ein erstes anorganisches Verkapselungsmuster (LIP1) umfasst, das auf dem ersten lichtemittierenden Element (ED1) angeordnet ist, und ein zweites anorganisches Verkapselungsmuster (LIP2), das auf dem zweiten lichtemittierenden Element (ED2) angeordnet ist und von dem ersten anorganischen Verkapselungsmuster (LIP1) beabstandet ist; und
das organische Muster (OLP1, OLP2, OLP3) ein erstes organisches Muster (OLP1 umfasst), das auf dem ersten anorganischen Verkapselungsmuster (LIP1) angeordnet ist, und ein zweites organisches Muster (OLP2), das auf dem zweiten anorganischen Verkapselungsmuster (LIP2) angeordnet und vom ersten organischen Muster (OLP1) beabstandet ist.

6. Anzeigefeld (DP) nach Anspruch 5, wobei der anorganische Film (IOL) Folgendes umfasst:
einen ersten anorganischen Abschnitt (IOP1), der auf dem ersten organischen Muster (OLP1) angeordnet ist; und
einen zweiten anorganischen Abschnitt (IOP2), der auf dem zweiten organischen Muster (OLP2) angeordnet ist,
wobei der erste anorganische Abschnitt (IOP1) und der zweite anorganische Abschnitt (IOP2) unterschiedliche Dicken voneinander aufweisen.

7. Anzeigefeld (DP) nach Anspruch 5, wobei der anorganische Film (IOL) Folgendes umfasst:
einen ersten anorganischen Abschnitt (IOP1), der auf dem ersten organischen Muster (OLP1) angeordnet ist; und
einen zweiten anorganischen Abschnitt (IOP2), der auf dem zweiten organischen Muster (OLP2) angeordnet ist,
wobei sich der erste anorganische Abschnitt (IOP1) und der zweite anorganische Abschnitt (IOP2) so auf die Bankschicht (CPW) erstrecken, dass sie miteinander verbunden sind.

8. Anzeigefeld (DP) nach einem der Ansprüche 1 bis 7, wobei das organische Muster (OLP1, OLP2, OLP3) in einer Draufsicht das anorganische Verkapselungsmuster (LIP1, LIP2, LIP3) vollständig bedeckt.

9. Anzeigefeld (DP) nach einem der Ansprüche 1 bis 8, wobei der anorganische Film (IOL) Folgendes umfasst:
ein Abstandsabschnitt (SPP1, SPP2, SPP3), der zwischen dem Dummy-Muster (DMP1, DMP2, DMP3) und der Bankschicht (CPW) angeordnet ist; und
einen Schichtabschnitt (LP1, LP2, LP3), der eine Form aufweist, die vom Abstandsabschnitt (SPP1, SPP2, SPP3) getrennt ist und obere Abschnitte des organischen Musters (OLP1, OLP2, OLP3) und die Bankschicht (CPW) bedeckt.

10. Anzeigefeld (DP) nach einem der Ansprüche 1 bis 9, weiter umfassend ein auf der Kathode (CE1, CE2, CE3) der Vielzahl von lichtemittierenden Elementen (ED1, ED2, ED3) angeordnetes Deckmuster (CP1, CP2, CP3).

11. Anzeigefeld (DP) nach einem der Ansprüche 1 bis 9, wobei:
das anorganische Verkapselungsmuster (LIP1, LIP2, LIP3) direkt auf der Kathode (CE1, CE2, CE3) und dem Dummy-Muster (DMP1, DMP2, DMP3) angeordnet ist;
das organische Muster (OLP1, OLP2, OLP3) direkt auf dem anorganischen Verkapselungsmuster (LIP1, LIP2, LIP3) angeordnet ist; und
der anorganische Film (IOL) direkt auf dem organischen Muster (OLP1, OLP2, OLP3) angeordnet ist.

12. Anzeigefeld (DP) nach einem der Ansprüche 1 bis 11, weiter umfassend:
eine organische Verkapselungsfolie (OL), die auf der anorganischen Folie (IOL) angeordnet ist und eine ebene Oberseite bereitstellt; und
eine obere anorganische Verkapselungsfolie (UIL), die auf der organischen Verkapselungsfolie (OL) angeordnet ist.

13. Anzeigefeld (DP) nach einem der Ansprüche 1 bis 12, wobei:
die Bankschicht (CPW) eine erste leitfähige Schicht (CDL1) umfasst, die auf dem Pixeldefinitionsfolie (ISL) angeordnet ist, und eine zweite leitfähige Schicht (CDL2), die auf der ersten leitfähigen Schicht (CDL1) angeordnet ist und eine unterschnittene Form aufweist, die von einer Seite der ersten leitfähigen Schicht (CDL1) vorsteht; und
das Dummy-Muster (DMP1, DMP2, DMP3) auf der zweiten leitfähigen Schicht (CDL2) angeordnet ist.

14. Verfahren zur Herstellung eines Anzeigefelds (DP), wobei das Verfahren Folgendes umfasst:
Bereitstellen eines Vorläufers eines Anzeigefelds, der eine Basisschicht (BL), eine erste Anode (AE1), die auf der Basisschicht (BL) angeordnet ist, einen Vorläufer der Pixeldefinitionsfolienvorläufer (ISL-I1), der auf der Basisschicht (BL) angeordnet ist und die erste Anode (AE1) bedeckt, und einen Vorläufer der Bankschicht (CDL1-I1), der auf dem Pixeldefinitionsfolienvorläufer (ISL-I1) angeordnet ist und ein leitfähiges Material umfasst, umfasst;
Definieren einer ersten Pixelöffnung (OP1-P), die der ersten Anode (AE1) entspricht und eine Oberseite der ersten Anode (AE1) im Vorläufer der Bankschicht (CDL1-I1) freilegt;
Bilden eines ersten lichtemittierenden Elements (ED1) in der ersten Pixelöffnung (OP1- P) durch sequentielles Bilden eines ersten lichtemittierenden Musters (EP1) und einer ersten Kathode (CE1) auf der ersten Anode (AE1);
Bilden eines Vorläufers der ersten anorganischen Verkapselungsschicht (LIL1), der das erste lichtemittierende Element (ED1) und den Vorläufer der Bankschicht (CDL1-I1) bedeckt;
Bilden eines ersten organischen Musters (OLP1), das das erste lichtemittierende Element (ED1) zumindest teilweise überlappt, auf dem der Vorläufer der ersten anorganischen Verkapselungsschicht (LIL1);
Bilden eines ersten anorganischen Verkapselungsmusters (LIP1), das das erste lichtemittierende Element (ED1) zumindest teilweise überlappt, durch Ätzen des Vorläufer der ersten anorganischen Verkapselungsschicht (LIL1) unter Verwendung des ersten organischen Musters (OLP1) als Maske; und
Bilden eines Vorläufers des ersten anorganischen Films (IOL-1) auf dem ersten organischen Muster (OLP1) und dem Vorläufer der Bankschicht (CDL1-I1),
wobei ein Teil des Vorläufers des ersten anorganischen Films (IOL-1) zwischen dem ersten anorganischen Verkapselungsmuster (LIP1) und dem Vorläufer der Bankschicht (CDL1-I1) angeordnet ist.

15. Verfahren nach Anspruch 14, wobei:
der Vorläufer des Anzeigefelds weiter eine zweite Anode (AE2) umfasst, die auf der Basisschicht (BL) angeordnet ist;
die Pixeldefinitionsfolie (ISL) die zweite Anode (AE2) bedeckt; und
nach dem Bilden des Vorläufers des ersten anorganischen Films (IOL-1) das Verfahren weiter Folgendes umfasst:
Definieren einer zweiten Pixelöffnung (OP2-P), die der zweiten Anode (AE2) entspricht und eine Oberseite der zweiten Anode (AE2) im Vorläufer der Bankschicht (CDL1-I1) freilegt;
Bilden eines zweiten lichtemittierenden Elements (ED2) in der zweiten Pixelöffnung (OP2-P) durch sequentielles Bilden eines zweiten lichtemittierenden Musters (EP2) und einer zweiten Kathode (CE2) auf der zweiten Anode (AE2);
Bilden eines Vorläufers der zweiten anorganischen Verkapselungsschicht (LIL2), der das zweite lichtemittierende Element (ED2) und den Vorläufer der Bankschicht (CDL1-I1) bedeckt;
Bilden eines zweiten organischen Musters (OLP2), das das zweite lichtemittierende Element (ED2) zumindest teilweise überlappt, auf dem Vorläufer der zweiten anorganischen Verkapselungsschicht (LIL2);
Bilden eines zweiten anorganischen Verkapselungsmusters (LIP2), das das zweite lichtemittierende Element (ED2) zumindest teilweise überlappt, durch Ätzen des Vorläufers der zweiten anorganischen Verkapselungsschicht (LIL2) unter Verwendung des zweiten organischen Musters (OLP2) als Maske; und
Bilden eines Vorläufers des zweiten anorganischen Films (IOL-2) auf dem zweiten organischen Muster (OLP2) und dem Vorläufer der Bankschicht (CDL1-I1).

## Revendications

1. Panneau d'affichage (DP) comprenant :
une couche de base (BL) ;
un film de définition de pixels (ISL) disposé sur la couche de base (BL) et comprenant un matériau inorganique ;
une couche de banc (CPW) qui est disposée sur le film de définition de pixels (ISL) et dans laquelle une pluralité d'ouvertures de pixels (OP1-P, OP2-P, OP3-P) est définie ;
une pluralité d'éléments électroluminescents (ED1, ED2, ED3) disposés dans chacune des pluralités d'ouvertures de pixels (OP1-P, OP2-P, OP3-P) et comprenant :
une anode (AE1, AE2, AE3) ;
un motif d'émission de lumière (EP1, EP2, EP3) ; et
une cathode (CE1, CE2, CE3) qui entre en contact avec la couche de banc (CPW);
un motif factice (DMP1, DMP2, DMP3) disposé sur la couche de banc (CPW) ;
un motif d'encapsulation inorganique (LIP1, LIP2, LIP3) disposé sur la cathode (CE1, CE2, CE3) et comprenant une partie disposée sur le motif factice (DMP1, DMP2, DMP3) ;
un motif organique (OLP1, OLP2, OLP3) disposé sur le motif d'encapsulation inorganique (LIP1, LIP2, LIP3) ; et
un film inorganique (IOL) disposé sur le motif organique (OLP1, OLP2, OLP3),
**caractérisé en ce qu'**une partie du film inorganique (IOL) est disposée entre le motif factice (DMP1, DMP2, DMP3) et la couche de banc (CPW).

2. Panneau d'affichage (DP) selon la revendication 1, dans lequel :
la pluralité d'ouvertures de pixels (OP1-P, OP2-P, OP3-P) comprend une première ouverture de pixel (OP1-P) et une seconde ouverture de pixel (OP2-P) espacées l'une de l'autre ; et
un élément électroluminescent (ED) parmi la pluralité d'éléments électroluminescents (ED1, ED2, ED3) comprend :
un premier élément électroluminescent (ED1) disposé dans la première ouverture de pixel (OP1-P) et comprenant une première anode (AE1), un premier motif électroluminescent (EP1) et une première cathode (CE1) ; et
un second élément électroluminescent (ED2) disposé dans la seconde ouverture de pixel (OP2-P) et comprenant une seconde anode (AE2), un second motif électroluminescent (EP2) et une seconde cathode (CE2).

3. Panneau d'affichage (DP) selon la revendication 2, dans lequel le motif factice (DMP1, DMP2, DMP3) comprend :
un premier motif factice (DMP1) disposé de manière adjacente à la première ouverture de pixel (OP1-P) ; et
un second motif factice (DMP2) disposé de manière adjacente à la seconde ouverture de pixel (OP2-P),
dans lequel :
le premier motif factice (DMP1) est séparé du premier motif électroluminescent (EP1) et de la première cathode (CE1) ; et
le second motif factice (DMP2) est séparé du second motif électroluminescent (EP2) et de la seconde cathode (CE2).

4. Panneau d'affichage (DP) selon la revendication 3, comprenant en outre un motif inorganique supplémentaire (AIL1) disposé entre le second motif factice (DMP2) et la couche de banc (CPW).

5. Panneau d'affichage (DP) selon l'une quelconque des revendications 2 à 4, dans lequel :
le motif d'encapsulation inorganique (LIP1, LIP2, LIP3) comprend un premier motif d'encapsulation inorganique (LIP1) disposé sur le premier élément électroluminescent (ED1) et un second motif d'encapsulation inorganique (LIP2) disposé sur le second élément électroluminescent (ED2) et espacé du premier motif d'encapsulation inorganique (LIP1) ; et
le motif organique (OLP1, OLP2, OLP3) comprend un premier motif organique (OLP1) disposé sur le premier motif d'encapsulation inorganique (LIP1) et un second motif organique (OLP2) disposé sur le second motif d'encapsulation inorganique (LIP2) et espacé du premier motif organique (OLP1).

6. Panneau d'affichage (DP) selon la revendication 5, dans lequel le film inorganique (IOL) comprend :
une première partie inorganique (IOP1) disposée sur le premier motif organique (OLP1) ; et
une seconde partie inorganique (IOP2) disposée sur le second motif organique (OLP2),
dans lequel la première partie inorganique (IOP1) et la seconde partie inorganique (IOP2) présentent des épaisseurs différentes l'une de l'autre.

7. Panneau d'affichage (DP) selon la revendication 5, dans lequel le film inorganique (IOL) comprend :
une première partie inorganique (IOP1) disposée sur le premier motif organique (OLP1) ; et
une seconde partie inorganique (IOP2) disposée sur le second motif organique (OLP2),
dans lequel la première partie inorganique (IOP1) et la seconde partie inorganique (IOP2) s'étendent sur la couche de banc (CPW) de manière à être connectées l'une à l'autre.

8. Panneau anneau d'affichage (DP) selon l'une quelconque des revendications 1 à 7, dans lequel le motif organique (OLP1, OLP2, OLP3) couvre l'intégralité du motif d'encapsulation inorganique (LIP1, LIP2, LIP3) dans une vue en plan.

9. Panneau d'affichage (DP) selon l'une quelconque des revendications 1 à 8, dans lequel le film inorganique (IOL) comprend :
une partie d'espacement (SPP1, SPP2, SPP3) disposée entre le motif factice (DMP1, DMP2, DMP3) et la couche de banc (CPW) ; et
une partie de couche (LP1, LP2, LP3) présentant une forme séparée de la partie d'espacement (SPP1, SPP2, SPP3) et couvrant les parties supérieures du motif organique (OLP1, OLP2, OLP3) et la couche de banc (CPW).

10. Panneau d'affichage (DP) selon l'une quelconque des revendications 1 à 9, comprenant en outre un motif de recouvrement (CP1, CP2, CP3) disposé sur la cathode (CE1, CE2, CE3) de la pluralité d'éléments électroluminescents (ED1, ED2, ED3).

11. Panneau d'affichage (DP) selon l'une quelconque des revendications 1 à 9, dans lequel :
le motif d'encapsulation inorganique (LIP1, LIP2, LIP3) est disposé directement sur la cathode (CE1, CE2, CE3) et le motif factice (DMP1, DMP2, DMP3) ;
le motif organique (OLP1, OLP2, OLP3) est disposé directement sur le motif d'encapsulation inorganique (LIP1, LIP2, LIP3) ; et
le film inorganique (IOL) est disposé directement sur le motif organique (OLP1, OLP2, OLP3).

12. Panneau d'affichage (DP) selon l'une quelconque des revendications 1 à 11, comprenant en outre :
un film organique d'encapsulation (OL) disposé sur le film inorganique (IOL) et présentant une surface supérieure plane ; et
un film inorganique d'encapsulation supérieur (UIL) disposé sur le film organique d'encapsulation (OL).

13. Panneau d'affichage (DP) selon l'une quelconque des revendications 1 à 12, dans lequel :
la couche de banc (CPW) comprend une première couche conductrice (CDL1) disposée sur le film de définition des pixels (ISL) et une seconde couche conductrice (CDL2) disposée sur la première couche conductrice (CDL1) et présentant une forme en contre-dépouille faisant saillie d'un côté de la première couche conductrice (CDL1) ; et
le motif factice (DMP1, DMP2, DMP3) est disposé sur la seconde couche conductrice (CDL2).

14. Procédé de fabrication d'un panneau d'affichage (DP), le procédé comprenant :
la fourniture d'un panneau d'affichage préliminaire comprenant une couche de base (BL), une première anode (AE1) disposée sur la couche de base (BL), un film de définition de pixels préliminaire (ISL-I1) disposé sur la couche de base (BL) et recouvrant la première anode (AE1), et une couche de banc préliminaire (CDL1-I1) disposée sur le film de définition de pixel préliminaire (ISL-I1) et comprenant un matériau conducteur ;
la définition d'une première ouverture de pixel (OP1-P), qui correspond à la première anode (AE1) et expose une surface supérieure de la première anode (AE1), dans la couche de banc préliminaire (CDL1-I1) ;
la formation d'un premier élément électroluminescent (ED1) dans la première ouverture de pixel (OP1- P) en formant séquentiellement un premier motif électroluminescent (EP1) et une première cathode (CE1) sur la première anode (AE1) ;
la formation d'une première couche d'encapsulation inorganique préliminaire (LIL1) recouvrant le premier élément électroluminescent (ED1) et la couche de banc préliminaire (CDL1-I1) ;
la formation d'un premier motif organique (OLP1) qui chevauche au moins partiellement le premier élément électroluminescent (ED1), sur la première couche d'encapsulation inorganique préliminaire (LIL1) ;
la formation d'un premier motif d'encapsulation inorganique (LIP1) chevauchant au moins partiellement le premier élément électroluminescent (ED1) en gravant la première couche d'encapsulation inorganique préliminaire (LIL1) à l'aide du premier motif organique (OLP1) comme masque ; et
la formation d'un premier film inorganique préliminaire (IOL-1) sur le premier motif organique (OLP1) et la couche de banc préliminaire (CDL1-I1),
dans lequel une partie du premier film inorganique préliminaire (IOL-1) est disposée entre le premier motif d'encapsulation inorganique (LIP1) et la couche de banc préliminaire (CDL1-I1).

15. Procédé selon la revendication 14, dans lequel :
le panneau d'affichage préliminaire comprend en outre une seconde anode (AE2) disposée sur la couche de base (BL) ;
le film de définition des pixels (ISL) recouvre la seconde anode (AE2) ; et
après la formation du premier film inorganique préliminaire (IOL-1), le procédé comprend en outre :
la définition d'une seconde ouverture de pixel (OP2-P), qui correspond à la seconde anode (AE2) et expose une surface supérieure de la seconde anode (AE2), dans la couche de banc préliminaire (CDL1-I1) ;
la formation d'un second élément électroluminescent (ED2) dans la seconde ouverture de pixel (OP2-P) en formant séquentiellement un second motif électroluminescent (EP2) et une seconde cathode (CE2) sur la seconde anode (AE2) ;
la formation d'une seconde couche d'encapsulation inorganique préliminaire (LIL2) recouvrant le second élément électroluminescent (ED2) et la couche de banc préliminaire (CDL1-I1) ;
la formation d'un second motif organique (OLP2), qui chevauche au moins partiellement le second élément électroluminescent (ED2), sur la seconde couche d'encapsulation inorganique préliminaire (LIL2) ;
la formation d'un second motif d'encapsulation inorganique (LIP2) chevauchant au moins partiellement le second élément électroluminescent (ED2) en gravant la seconde couche d'encapsulation inorganique préliminaire (LIL2) à l'aide du second motif organique (OLP2) comme masque ; et
la formation d'un second film inorganique préliminaire (IOL-2) sur le second motif organique (OLP2) et la couche de banc préliminaire (CDL1-I1).
